# EUROPEAN PATENT APPLICATION

(11) **EP 4 542 642 A1**
(43) Date of publication of application: **23.04.2025**
(21) Application number: 23823696.2
(22) Date of filing: 30.05.2023
(51) Int. Cl.: H01L 23/38, H01L 21/52, H01L 23/10, H01L 25/16, H01L 27/146

(54) **SEMICONDUCTOR DEVICE AND ELECTRONIC APPLIANCE**

(30) Priority: 15.06.2022 JP 2022096685
(71) Applicant: Sony Semiconductor Solutions Corporation, Atsugi-shi, Kanagawa 243-0014 (JP)
(72) Inventor: KOBAYASHI, Tatehito, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/020159
(87) International publication number: WO 2023/243402

(57) **Abstract**

Provided are a semiconductor device for which it is possible to simply perform an inspection of bonding between a cooling device for a semiconductor element such as a Peltier element, and a substrate in a PGA package, and an electronic apparatus including the semiconductor device.

The semiconductor device according to the present disclosure includes: a semiconductor element; a cooling device on which the semiconductor element is bonded to an upper surface and that transfers heat generated by the semiconductor element to a heat dissipation portion; a semiconductor package including a cavity that accommodates the semiconductor element and the cooling device; an electrode formed in the heat dissipation portion of the cooling device; an electrode formed in the heat dissipation portion of the cooling device; a terminal formed on a bottom surface of the cavity to face the electrode; a conductive resin that bonds the electrode and the terminal together; and at least one or more detection pattern portions having conductivity for detecting wet spreading of the conductive resin interposed between the electrode and the terminal. Furthermore, the electronic apparatus including the semiconductor device is configured.

## Description

### TECHNICAL FIELD

The present disclosure relates to a semiconductor device configured to cool a semiconductor element disposed in a semiconductor package with a cooling device for the semiconductor element, such as a Peltier element, interposed therebetween, and an electronic apparatus including the semiconductor device.

### BACKGROUND ART

Conventionally, with the progress of miniaturization of a semiconductor process and the increase in speed of a semiconductor element, high integration of the semiconductor element has progressed. In response to the progress of high integration of semiconductor elements, various semiconductor structures and packages have appeared. Furthermore, the power consumption of the semiconductor element also increases with high integration, and it is a problem to suppress a temperature rise accompanying this.

As a configuration for suppressing a temperature rise of a semiconductor device, for example, a package structure is known in which a heat sink or a Peltier element is incorporated as a cooling device in a semiconductor device. However, when such an element is incorporated, the package structure of the semiconductor device becomes complicated, and thus there are problems that capital investment in an inspection process for soldering and the like becomes expensive, and a tact time becomes long, for example.

Patent Document 1 discloses a semiconductor device including a semiconductor module, a fin base having a first surface to which the semiconductor module is attached and a second surface arranged on an opposite side from the semiconductor module with respect to the first surface, and a heat sink including a plurality of fin portions arranged on an opposite side from the semiconductor module with respect to the fin base, in which the plurality of fin portions of the heat sink is bonded to the second surface.

Specifically, in the semiconductor device, the semiconductor module is bonded, by a first solder portion, to the first surface that is an upper surface of the fin base having a substantially rectangular shape and a substantially flat plate shape in plan view. Furthermore, the plurality of fin portions each having a substantially truncated conical root portion and a substantially cylindrical shaft portion connected to the root portion is vertically provided on the second surface that is a lower surface of the fin base.

A process in which the plurality of fin portions is vertically provided on the second surface of the fin base is configured as follows. That is, the semiconductor module is bonded, by the first solder portion, to the first surface that is the upper surface of the fin base. Thereafter, presence or absence of defective solder and the like is inspected by an X-ray inspection device. Next, the plurality of fin portions is bonded, by rotary friction welding, to the second surface that is the lower surface of the fin base of a good product. That is, the semiconductor module is soldered to the fin base first, and the plurality of fin portions is vertically provided after an inspection of soldering. The semiconductor device is formed by the process as described above.

Since the semiconductor device is formed as described above, it is not necessary to form irregularities such as a crimping structure on the fin base, and it is not necessary to attach and detach a protective cover when the semiconductor module is attached to the first surface of the fin base. Furthermore, since a heat capacity and a surface area of the fin base are smaller than those in a case where the fin base is provided with the plurality of fin portions, a time required for bonding by the first solder portion is reduced.

Moreover, when a bonded state of the semiconductor module is subjected to X-ray inspection, the plurality of fin portions is not reflected, so that a time required for analysis of the X-ray inspection can be shortened, and the cost is reduced. As a result, it is possible to provide a semiconductor device manufacturing method having high productivity and a semiconductor device.

### CITATION LIST

### PATENT DOCUMENT

Patent Document 1: Japanese Patent Application Laid-Open No. 2021-158255

### SUMMARY OF THE INVENTION

### PROBLEMS TO BE SOLVED BY THE INVENTION

As described above, the semiconductor device described in Patent Document 1 is configured such that the semiconductor module is solder-bonded to the first surface of the fin base having the substantially flat plate shape by the first solder portion, and then, the X-ray inspection is performed, and after the X-ray inspection is ended, the plurality of fin portions is bonded to the second surface by rotary friction welding to form the heat sink.

However, in the X-ray inspection, inspection equipment is expensive, and it takes time for setup or the like of the X-ray inspection.

Furthermore, in a case where the semiconductor element or the semiconductor module is fixed by soldering, there is a problem that the position and inclination cannot be controlled with high accuracy, which affects the tilt angle. Moreover, in a case where the semiconductor module as a heat source is solder-bonded onto the first surface of the fin base, thermal conductivity of solder is not necessarily high, and thus there is a problem that heat generation and a voltage drop occur at a solder-bonded portion.

The present disclosure has been made in view of such problems, and an object of the present disclosure is to provide a semiconductor device for which it is possible to simply perform an inspection of bonding between a cooling device for a semiconductor element such as a Peltier element, and a substrate in a semiconductor package such as a PGA package, and an electronic apparatus including the semiconductor device.

### SOLUTIONS TO PROBLEMS

The present disclosure has been made to solve the above-described problems, and a first aspect thereof is
a semiconductor device including:
a semiconductor element;
a cooling device on which the semiconductor element is bonded to an upper surface and that transfers heat generated by the semiconductor element to a heat dissipation portion;
a semiconductor package including a cavity that accommodates the semiconductor element and the cooling device;
an electrode formed in the heat dissipation portion of the cooling device;
a terminal formed on a bottom surface of the cavity to face the electrode;
a conductive resin that bonds the electrode and the terminal together; and
at least one or more detection pattern portions having conductivity for detecting wet spreading of the conductive resin interposed between the electrode and the terminal.

Furthermore, in the first aspect, the detection pattern portion may be insulated and disposed on a surface on which the terminal is formed, and may be configured to detect wet spreading of the conductive resin on the basis of a value of capacitance between the detection pattern portion and the terminal.

Furthermore, in the first aspect, the detection pattern portion may be disposed on a surface on which the terminal is formed in a non-insulated manner, and may be configured to detect wet spreading of the conductive resin on the basis of a value of resistance between the detection pattern portion and the terminal.

Furthermore, in the first aspect, the detection pattern portion may be insulated and disposed on a surface on which the electrode is formed, and may be configured to detect wet spreading of the conductive resin on the basis of a value of capacitance between the detection pattern portion and the electrode.

Furthermore, in the first aspect, the detection pattern portion may be disposed on a surface on which the electrode is formed in a non-insulated manner, and may be configured to detect wet spreading of the conductive resin on the basis of a value of resistance between the detection pattern portion and the electrode.

Furthermore, in the first aspect, the detection pattern portion may be insulated and disposed on a surface on which the electrode is formed, and may be configured to detect wet spreading of the conductive resin on the basis of a value of capacitance between the detection pattern portion and the terminal.

Furthermore, in the first aspect, the detection pattern portion may be disposed on a surface on which the electrode is formed in a non-insulated manner, and may be configured to detect wet spreading of the conductive resin on the basis of a value of resistance between the detection pattern portion and the terminal.

Furthermore, in the first aspect, the detection pattern portion may be insulated and disposed on a surface on which the terminal is formed, and may be configured to detect wet spreading of the conductive resin on the basis of a value of capacitance between the detection pattern portion and the electrode.

Furthermore, in the first aspect, the detection pattern portion may be disposed on a surface on which the terminal is formed in a non-insulated manner, and may be configured to detect wet spreading of the conductive resin on the basis of a value of resistance between the detection pattern portion and the electrode.

Furthermore, in the first aspect, the detection pattern portion may be formed linearly, and at least one detection pattern portion may be disposed between a plurality of the terminals and between the terminal and an inner wall of the cavity.

Furthermore, in the first aspect, the detection pattern portion may be formed in a plurality of small detection pattern portions, and a plurality of the detection pattern portions may be disposed between a plurality of the terminals and between the terminal and an inner wall of the cavity.

Furthermore, in the first aspect, the detection pattern portion may be formed linearly, and at least one detection pattern portion may be disposed between a plurality of the electrodes and between the electrode and an inner wall of the cavity.

Furthermore, in the first aspect, the detection pattern portion may be formed in a plurality of small detection pattern portions, and a plurality of the detection pattern portions may be disposed between a plurality of the electrodes and between the electrode and an inner wall of the cavity.

Furthermore, in the first aspect, the small detection pattern portion may be formed in a substantially short linear shape, a substantially rectangular shape, a substantially triangular shape, or a substantially circular shape in plan view.

Furthermore, in the first aspect, insulation of the detection pattern portion may be aluminum oxide (Al₂O₃).

Furthermore, in the first aspect, insulation of the detection pattern portion may be an insulating resin.

Furthermore, in the first aspect, the cooling device may include a Peltier element.

A second aspect thereof is
an electronic apparatus including a semiconductor device including:
a semiconductor element;
a cooling device on which the semiconductor element is bonded to an upper surface and that transfers heat generated by the semiconductor element to a heat dissipation portion;
a semiconductor package including a cavity that accommodates the semiconductor element and the cooling device;
an electrode formed in the heat dissipation portion of the cooling device;
a terminal formed on a bottom surface of the cavity to face the electrode;
a conductive resin that bonds the electrode and the terminal together; and
at least one or more detection pattern portions having conductivity for detecting wet spreading of the conductive resin interposed between the electrode and the terminal.

By adopting the aspect described above, it is possible to provide a semiconductor device for which it is possible to simply perform an inspection of bonding between a cooling device for a semiconductor element such as a Peltier element to which the semiconductor element is bonded and a semiconductor package, and an electronic apparatus including the semiconductor device.

### BRIEF DESCRIPTION OF DRAWINGS

Fig. 1 is an exploded perspective view of a semiconductor device according to the present disclosure.
Fig. 2 is a plan view of a first embodiment of the semiconductor device according to the present disclosure.
Fig. 3 is an X-X line cut end view of the first embodiment of the semiconductor device according to the present disclosure.
Fig. 4 is an explanatory diagram of an inspection method when there is no wet spreading in the first embodiment of the semiconductor device according to the present disclosure.
Fig. 5 is an explanatory diagram of an inspection method when wet spreading occurs in the first embodiment of the semiconductor device according to the present disclosure.
Fig. 6 is an explanatory diagram of a manufacturing process of the first embodiment of the semiconductor device according to the present disclosure (part 1).
Fig. 7 is an explanatory diagram of the manufacturing process of the first embodiment of the semiconductor device according to the present disclosure (part 2).
Fig. 8 is an explanatory diagram of the manufacturing process of the first embodiment of the semiconductor device according to the present disclosure (part 3).
Fig. 9 is an explanatory diagram of the manufacturing process of the first embodiment of the semiconductor device according to the present disclosure (part 4).
Fig. 10 is an explanatory diagram of the manufacturing process of the first embodiment of the semiconductor device according to the present disclosure (part 5).
Fig. 11 is an explanatory diagram of the manufacturing process of the first embodiment of the semiconductor device according to the present disclosure (part 6).
Fig. 12 is an explanatory diagram of the manufacturing process of the first embodiment of the semiconductor device according to the present disclosure (part 7).
Fig. 13 is an explanatory diagram of the manufacturing process of the first embodiment of the semiconductor device according to the present disclosure (part 8).
Fig. 14 is an explanatory diagram of the manufacturing process of the first embodiment of the semiconductor device according to the present disclosure (part 9).
Fig. 15 is a plan view of a second embodiment of the semiconductor device according to the present disclosure.
Fig. 16 is an X-X line cut end view of the second embodiment of the semiconductor device according to the present disclosure.
Fig. 17 is an explanatory diagram of an inspection method when there is no wet spreading in the second embodiment of the semiconductor device according to the present disclosure.
Fig. 18 is an explanatory diagram of an inspection method when wet spreading occurs in the second embodiment of the semiconductor device according to the present disclosure.
Fig. 19 is a plan view of a third embodiment of the semiconductor device according to the present disclosure.
Fig. 20 is an X-X line cut end view of the third embodiment of the semiconductor device according to the present disclosure.
Fig. 21 is an explanatory diagram of an inspection method when there is no wet spreading in the third embodiment of the semiconductor device according to the present disclosure.
Fig. 22 is an explanatory diagram of an inspection method when wet spreading occurs in the third embodiment of the semiconductor device according to the present disclosure.
Fig. 23 is a plan view of a fourth embodiment of the semiconductor device according to the present disclosure.
Fig. 24 is an X-X line cut end view of the fourth embodiment of the semiconductor device according to the present disclosure.
Fig. 25 is an explanatory diagram of an inspection method when there is no wet spreading in the fourth embodiment of the semiconductor device according to the present disclosure.
Fig. 26 is an explanatory diagram of an inspection method when wet spreading occurs in the fourth embodiment of the semiconductor device according to the present disclosure.
Fig. 27 is an explanatory diagram of an inspection method when there is no wet spreading in a fifth embodiment of the semiconductor device according to the present disclosure.
Fig. 28 is an explanatory diagram of an inspection method when wet spreading occurs in the fifth embodiment of the semiconductor device according to the present disclosure.
Fig. 29 is an explanatory diagram of an inspection method when there is no wet spreading in a sixth embodiment of the semiconductor device according to the present disclosure.
Fig. 30 is an explanatory diagram of an inspection method when wet spreading occurs in the sixth embodiment of the semiconductor device according to the present disclosure.
Fig. 31 is a plan view of a first modification of the first embodiment or the second embodiment of the semiconductor device according to the present disclosure.
Fig. 32 is a plan view of a second modification of the first embodiment or the second embodiment of the semiconductor device according to the present disclosure.
Fig. 33 is a plan view of a first modification of the third embodiment to the sixth embodiment of the semiconductor device according to the present disclosure.
Fig. 34 is a Y1-Y1 line cut end view of the first modification of the third embodiment to the sixth embodiment of the semiconductor device according to the present disclosure.
Fig. 35 is a Y2-Y2 line cut end view of the first modification of the third embodiment to the sixth embodiment of the semiconductor device according to the present disclosure.
Fig. 36 is a plan view of a second modification of the third embodiment to the sixth embodiment of the semiconductor device according to the present disclosure.
Fig. 37 is a Y3-Y3 line cut end view of the second modification of the third embodiment to the sixth embodiment of the semiconductor device according to the present disclosure.
Fig. 38 is a block diagram of an electronic apparatus including the semiconductor device according to the present disclosure.

### MODE FOR CARRYING OUT THE INVENTION

Next, modes for carrying out a semiconductor device according to the present disclosure (Hereinafter, they are referred to as "embodiments".) will be described in the following order with reference to the drawings. In the following drawings, the same or similar parts are denoted by the same or similar reference numerals. However, the drawings are schematic, and dimensional ratios and the like of the respective parts do not necessarily match actual ones. Furthermore, it is needless to say that the drawings include parts having different dimensional relationships and ratios.
1. First Embodiment of Semiconductor Device according to Present Disclosure
2. Manufacturing Process of First Embodiment of Semiconductor Device according to Present Disclosure
3. Second Embodiment of Semiconductor Device according to Present Disclosure
4. Third Embodiment of Semiconductor Device according to Present Disclosure
5. Fourth Embodiment of Semiconductor Device according to Present Disclosure
6. Fifth Embodiment of Semiconductor Device according to Present Disclosure
7. Sixth Embodiment of Semiconductor Device according to Present Disclosure
8. Modification of First Embodiment of Semiconductor Device according to Present Disclosure
9. Modification of Second Embodiment of Semiconductor Device according to Present Disclosure
10. First Modification of First Embodiment or Second Embodiment of Semiconductor Device according to Present Disclosure
11. Second Modification of First Embodiment or Second Embodiment of Semiconductor Device according to Present Disclosure
12. First Modification of Third Embodiment to Sixth Embodiment of Semiconductor Device according to Present Disclosure
13. Second Modification of Third Embodiment to Sixth Embodiment of Semiconductor Device according to Present Disclosure
14. Electronic Apparatus Including Semiconductor Device according to Present Disclosure

### <1. First Embodiment of Semiconductor Device according to Present Disclosure>

### [Basic Configuration of First Embodiment]

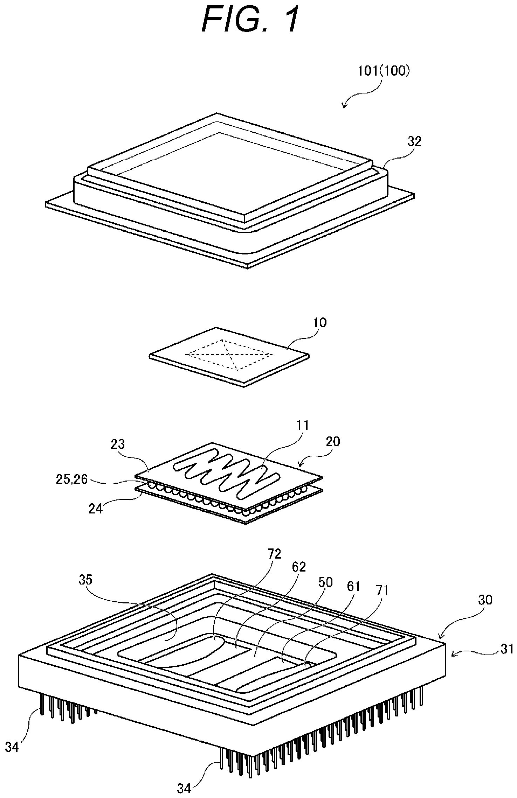

Fig. 1 is an exploded perspective view of a first embodiment of a semiconductor device 101 according to the present disclosure. The semiconductor device 101 is configured such that a semiconductor element 10 is bonded to an upper surface of a Peltier element 20 that is a cooling device by a die bond material 11, the Peltier element 20 is bonded to terminals 61 and 62 on a substrate 50 disposed in a cavity 35 of a PGA package 30 by conductive resins 71 and 72, and a glass lid 32 is placed on the cavity 35. Here, the cooling device for the semiconductor element 10 is not limited to the Peltier element 20, and may be another cooling device.

The pin grid array (PGA) package 30 is a type of semiconductor package, and includes the glass lid 32. The PGA package 30 has a role of accommodating the semiconductor element 10 therein, supplying power to the semiconductor element 10 and the like, inputting and outputting signals from and to external devices, protecting the semiconductor element 10 from an external environment, and dissipating heat generated by the semiconductor element 10 to the outside to cool the semiconductor element. For this reason, the PGA package 30 includes a package frame body 31 whose outer periphery has a substantially square shape and in which the cavity 35 having a square shape and a step is formed in a central portion. Then, a plurality of pins 34 for external connection is vertically provided on a lower surface of the package frame body 31. The cavity 35 is an accommodation space for the semiconductor element 10, the cooling device, and the like. To the substrate 50 that is a bottom portion of the cavity 35, the Peltier element 20 of which the semiconductor element 10 is bonded to an upper surface is bonded with the conductive resins 71 and 72 interposed therebetween.

Then, on an upper surface of the PGA package 30, as illustrated in Fig. 1, the glass lid 32 is placed and welded to cover the cavity 35, thereby protecting the semiconductor element 10 and the like from the external environment.

The first embodiment of the semiconductor device 101 according to the present disclosure is generally configured as described above.

Hereinafter, a basic configuration of the first embodiment will be described in more detail with reference to the drawings.

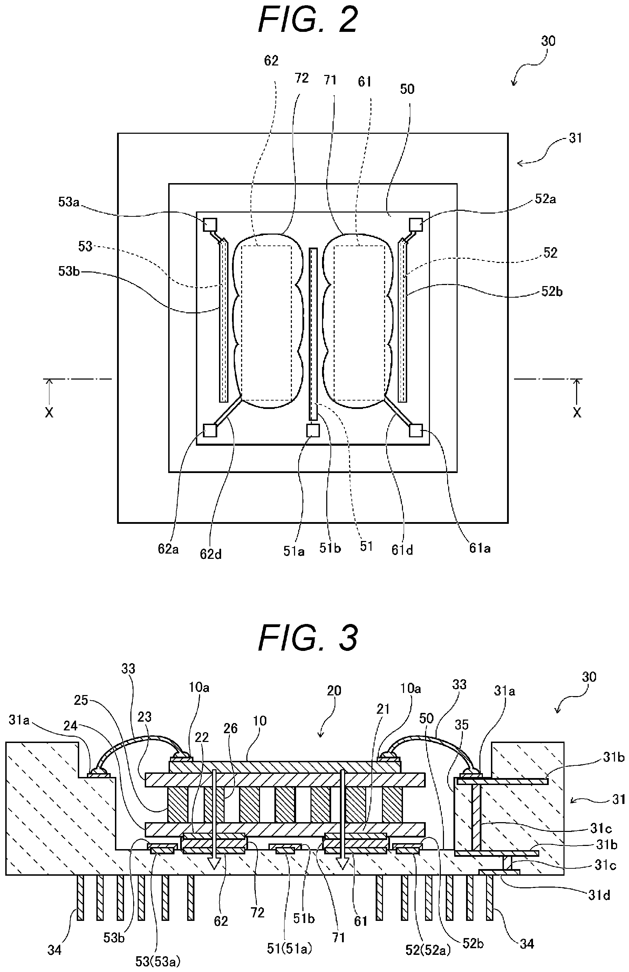

Fig. 2 is a plan view of the PGA package 30 before the Peltier element 20 is bonded to the substrate 50 in the first embodiment. Furthermore, Fig. 3 is an X-X line cut end view in Fig. 2 (hereinafter, the figures may be referred to as an "X end view" and a "plan view", respectively.). This similarly applies to the following.

Furthermore, for example, a direction parallel to a cutting line of an X-X line cut end surface is referred to as an "X direction", a right direction in the drawing is referred to as a "right side", and a left direction in the drawing is referred to as a "left side". Furthermore, a direction orthogonal to the "X direction" is referred to as a "Y direction", and an upward direction and a downward direction in the drawing are referred to as an "upper side" and a "lower side", respectively.

Furthermore, in the following description, it is assumed that live wire portions such as electrodes 21 and 22 and the terminals 61 and 62 are electrically insulated from other different electrodes or conductive portions in a predetermined manner although not illustrated.

On a lower surface of the PGA package 30, as illustrated in Fig. 3, in order to supply power to the semiconductor element 10 or the Peltier element 20 and input and output signals from and to external devices, the predetermined plurality of metal pins 34 is vertically provided by brazing or the like. Here, the semiconductor element 10 is an integrated circuit chip formed on a silicon substrate, and is, for example, a solid-state imaging element, a microprocessor, a memory, a logic circuit, a power element, or the like.

A wiring line between the semiconductor element 10 and each pin 34 is specifically configured as follows. First, as illustrated in Fig. 3, a connection terminal 10a is disposed on an upper surface peripheral edge of the semiconductor element 10. A step is formed on an inner peripheral surface of the cavity 35, and a connection terminal 31a is disposed on the step. Then, the connection terminal 10a and the connection terminal 31a are connected to each other by wire bonding with a gold wire (Au) 33 or the like, for example. The connection terminal 31a in the cavity 35 is connected to the pin 34 through a wiring line 31b, a via 31c, and a pad 31d formed inside the package frame body 31 and the substrate 50.

Electrical connection between the semiconductor element 10 and the pin 34 is formed as described above. However, the wiring line 31b, the via 31c, and the pad 31d illustrated in the figure illustrate part thereof, and illustration of connection states of the other pins 34 is omitted. Furthermore, in the drawings other than Fig. 3, in order to avoid complication, illustration is omitted of the connection terminals 10a and 31a, the gold wire (Au) 33 for wire bonding connection, the wiring line 31b, the via 31c, the pad 31d, and the like forming the electrical connection described above.

The Peltier element 20 is a cooling device using the Peltier effect. Specifically, when a P-type semiconductor 26 and an N-type semiconductor 25 are connected together in series, and for example, a DC current is caused to flow from the N-type semiconductor 25 in a direction toward the P-type semiconductor 26, heat is absorbed (cooled) at a connection portion between the P-type semiconductor 26 and the N-type semiconductor 25, and heat is dissipated (generated) on each of an anode side of the N-type semiconductor 25 and a cathode side of the P-type semiconductor 26.

In the first embodiment of the semiconductor device 101 according to the present disclosure, as illustrated in Fig. 2, the terminals 61 and 62 having a substantially rectangular shape in the Y direction are arranged side by side at a substantially central portion of an upper surface of the substrate 50 having a substantially square shape in plan view. Then, between the terminals 61 and 62, at substantially equal intervals to them, a detection pattern portion 51 is disposed in the Y direction. Furthermore, on a right side surface of the terminal 61, a detection pattern portion 52 is disposed in the Y direction along the right side surface. Similarly, on a left side surface of the terminal 62, a detection pattern portion 53 is disposed in the Y direction along the left side surface. That is, the detection pattern portion 52, the terminal 61, the detection pattern portion 51, the terminal 62, and the detection pattern portion 53 are disposed in parallel to each other in this order from the right in the figure.

The detection pattern portions 51, 52, and 53 have conductivity, and serve as sensors for detecting wet spreading of the conductive resins 71 and 72 when the Peltier element 20 is bonded to the substrate 50.

Furthermore, the detection pattern portions 51, 52, and 53 are covered with insulators 51b, 52b, 53b, respectively, and are electrically insulated. The insulators 51b, 52b, and 53b include, for example, aluminum oxide (Al₂O₃) or an insulating resin.

As illustrated in Fig. 2, the detection pattern portion 52 extends obliquely to a right upper side from an upper end thereof, and an inspection terminal 52a is connected to an extended end. As illustrated in the figure, the detection pattern portion 53 extends obliquely to a left upper side from an upper end thereof, and an inspection terminal 53a is connected to an extended end. Furthermore, as illustrated in the figure, the detection pattern portion 51 linearly extends to the lower side from a lower end thereof, and an inspection terminal 51a is connected to an extended end.

As illustrated in Fig. 2, in the terminal 61, a wiring pattern 61d is drawn out obliquely to a right lower side from a lower right corner thereof, and an inspection terminal 61a is connected to a drawn end. Furthermore, as illustrated in the figure, in the terminal 62, a wiring pattern 62d is drawn out obliquely to a left lower side from a lower left corner thereof, and an inspection terminal 62a is connected to a drawn end. The inspection terminals 51a, 52a, 53a, 61a, and 62a are terminals for connecting probes of a flying checker or the like for inspecting wet spreading of the conductive resins 71 and 72 by contact or the like.

As illustrated in Fig. 1 or 2, the conductive resins 71 and 72 are applied to upper surfaces of the terminals 61 and 62, respectively. Then, as illustrated in Fig. 1 or 3, the Peltier element 20 of which the semiconductor element 10 is bonded to the upper surface is placed on the conductive resins 71 and 72 and bonded to the substrate 50. As a result, the electrodes 21 and 22 on a lower surface of the Peltier element 20 are electrically connected to the terminals 61 and 62 on the substrate 50 through the conductive resins 71 and 72, respectively.

In Fig. 3, the Peltier element 20 has a structure in which a plurality of the N-type semiconductors 25 and a plurality of the P-type semiconductors 26, which have substantially rectangular shapes, are arranged on an upper surface of a ceramic substrate 24 (Hereinafter, it is referred to as "heat dissipation plate 24".) on a heat dissipation side, and on upper surfaces thereof, a ceramic substrate 23 (Hereinafter, it is referred to as "heat absorption plate 23".) is placed on a heat absorption side to which the semiconductor element 10 is bonded, and the N-type semiconductors 25 and the P-type semiconductors 26 are sandwiched between the heat dissipation plate 24 and the heat absorption plate 23. Then, the N-type semiconductor 25 and the P-type semiconductor 26 are connected together in series to form a cooling circuit (In the figure, a circuit diagram is not illustrated.).

Specifically, the circuit including the N-type semiconductor 25 and the P-type semiconductor 26 is configured such that one end of the N-type semiconductor 25 and one end of the P-type semiconductor 26 are connected together, the other end of the N-type semiconductor 25 is connected to the electrode 22 serving as an anode, the other end of the P-type semiconductor 26 is connected to the electrode 21 serving as a cathode, and a DC voltage is applied across the electrodes 22 and 21 to cause a DC current to flow. That is, a DC circuit is formed through the terminal 62, the conductive resin 72, the electrode 22, the N-type semiconductor 25, the P-type semiconductor 26, the electrode 21, the conductive resin 71, and the terminal 61.

When a DC current is caused to flow through the circuit configured as described above, a connection side between the one end of the N-type semiconductor 25 and the one end of the P-type semiconductor 26 absorbs heat generated by the semiconductor element 10 through the heat absorption plate 23 that is a heat absorption portion. On the other hand, the electrode 22 side to which the other end of the N-type semiconductor 25 is connected and the electrode 21 side to which the other end of the P-type semiconductor 26 is connected transfer heat to the heat dissipation plate 24 that is a heat dissipation portion.

The heat dissipation plate 24 transfers heat to the PGA package 30 through the electrodes 21 and 22, the conductive resins 71 and 72, and the terminals 61 and 62. Since the PGA package 30 includes, for example, ceramic having excellent thermal conductivity, the PGA package 30 itself dissipates heat to the atmosphere to cool the semiconductor element 10. Alternatively, in a case where the PGA package 30 includes a heat sink (not illustrated), heat is transferred to the heat sink, and the heat sink dissipate heat to the atmosphere to cool the semiconductor element 10. That is, the heat generated by the semiconductor element 10 is dissipated in a direction indicated by an arrow in Fig. 3. The configuration for cooling the semiconductor element 10 by the Peltier element 20 is as described above.

Note that the circuit formed by a combination of the N-type semiconductor 25 and the P-type semiconductor 26 may be further connected together in series by appropriately performing insulation processing on the heat absorption plate 23 and the heat dissipation plate 24, or the circuit formed by the N-type semiconductor 25 and the P-type semiconductor 26 may be connected together in parallel. Such a DC circuit can be formed by disposing a required number of the N-type semiconductors 25 and P-type semiconductors 26.

Here, as described above, the terminals 61 and 62 of the substrate 50 and the electrodes 21 and 22 of the Peltier element 20 are electrically and thermally connected through the conductive resins 71 and 72, respectively. The conductive resins 71 and 72 are, for example, silver (Ag) paste, or sintered copper bonding paste or diamond paste that is further excellent in bondability and thermal conductivity than silver paste. The silver paste is, for example, a conductive bonding material in which particles of silver (Ag) having conductivity are dispersed in paste of resin such as epoxy or urethane.

In recent years, in a solid-state imaging device 100, a requirement for tilt accuracy has become severe due to an increase in resolution and an increase in optical size. In a case where the semiconductor element 10 of the solid-state imaging device 100 is fixed by soldering, a position and an inclination of a component are determined by self-alignment. On the other hand, in the case of fixing with the conductive resins 71 and 72, it is determined by a posture at the time of mounting. Then, severe control is possible in the case of fixing with the conductive resins 71 and 72. Thus, the conductive resins 71 and 72 can cope with a higher accuracy requirement of the tilt accuracy than soldering.

Furthermore, in the case of the conductive resins 71 and 72, materials having excellent thermal conductivity have appeared in recent years. For example, the sintered copper bonding paste has a thermal conductivity of 180 W/(m•K), and has a sufficiently high thermal conductivity with respect to a thermal conductivity of 30 W/(m•K) of a general high lead solder. For this reason, it can be said that the conductive resins 71 and 72 are optimum die bonding materials for countermeasures against a temperature rise of the semiconductor device 101 as compared with solder.

However, since the conductive resins 71 and 72 are liquid immediately after application, when the Peltier element 20 is bonded to the substrate 50, there is a possibility that wet spreading occurs between the electrode 21 of the heat dissipation plate 24 and the terminal 61 of the substrate 50 or between the electrode 22 and the terminal 62. As a result, there is a problem that a short circuit occurs between the terminals 61 and 62 or between the electrodes 21 and 22 due to wet spreading.

Furthermore, when the Peltier element 20 is bonded to the substrate 50, the conductive resins 71 and 72 are hidden under the lower surface of the Peltier element 20, and thus, there has been no simple method for nondestructively confirming a wet state thereof. For example, it is possible to make a configuration in which X-rays or the like can be used and perform confirmation, but there is a problem that it takes time for setup and confirmation, and expensive inspection equipment is required.

Moreover, as the size of the package is reduced, a gap between a peripheral edge of the Peltier element 20 or the substrate 50 and a side wall of the cavity 35 is narrowed, and the conductive resins 71 and 72 protruding from the lower surface of the Peltier element 20 reach the side wall of the cavity 35, and in an extreme case, there may be a concern that the conductive resins crawl up the side wall.

Thus, in the first embodiment of the semiconductor device 101 according to the present disclosure, as illustrated in Fig. 2, the detection pattern portion 51 is disposed between the terminals 61 and 62, the detection pattern portion 52 is disposed on the right side surface of the terminal 61, and the detection pattern portion 53 is disposed on the left side surface of the terminal 62. Then, the inspection terminals 51a, 52a, and 53a are connected to the detection pattern portions 51, 52, and 53, respectively. Furthermore, as illustrated in the figure, the inspection terminals 61a and 62a are connected to the terminals 61 and 62, respectively.

Since the first embodiment of the semiconductor device 101 according to the present disclosure is configured as described above, an inspection of bonding between the Peltier element 20 and the substrate 50 disposed in the cavity 35 of the PGA package 30 can be simply performed by using the inspection terminals 51a, 52a, 53a, 61a, and 62a.

### [Wet Spreading Inspection Method of First Embodiment]

Next, a description will be given below of an inspection method for detecting wet spreading of the conductive resins 71 and 72 by the inspection terminals 51a, 52a, and 53a connected to the detection pattern portions 51, 52, and 53 and the inspection terminals 61a and 62a connected to the terminals 61 and 62.

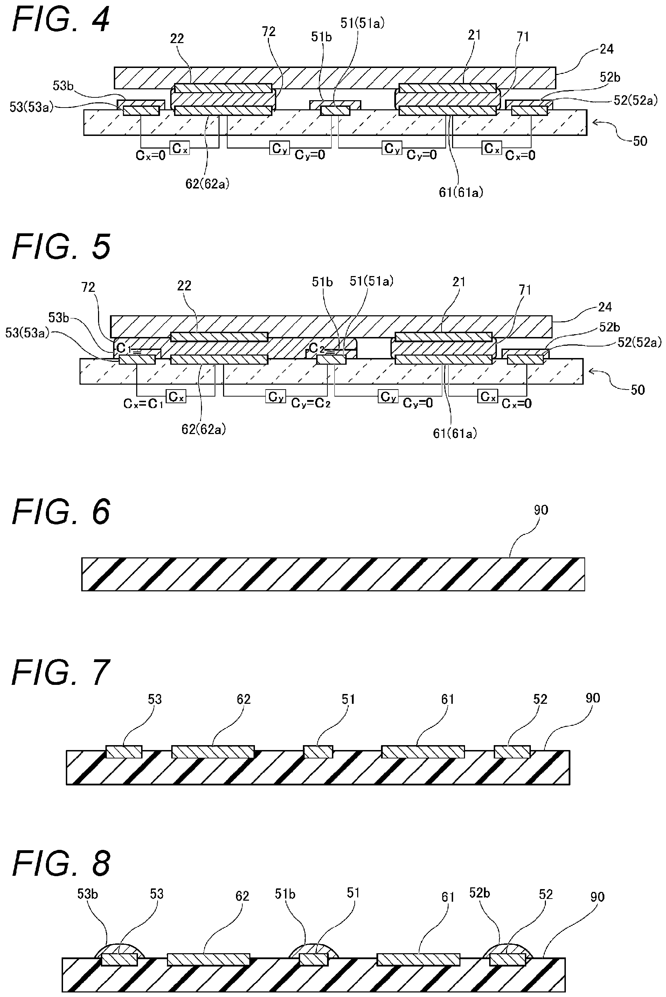

Fig. 4 is a partially enlarged explanatory diagram illustrating a bonded state when wet spreading of the conductive resins 71 and 72 does not occur between the terminals 61 and 62 of the substrate 50 and the electrodes 21 and 22 of the Peltier element 20 in the X end view illustrated in Fig. 3. In the example illustrated in Fig. 4, an appropriate amount of the conductive resin 72 is applied between the electrode 22 and the terminal 62. Similarly, an appropriate amount of the conductive resin 71 is also applied between the electrode 21 and the terminal 61. For this reason, wet spreading of the conductive resins 72 and 71 does not occur between the electrode 22 and the terminal 62 and between the electrode 21 and the terminal 61.

In this state, a capacitance Cx is measured between the terminal 62 and the detection pattern portion 53 on the substrate 50. Measurement of the capacitance Cx is performed by applying measurement probes (Not illustrated. The same applies hereinafter.) respectively to the inspection terminal 62a connected to the terminal 62 and the inspection terminal 53a connected to the detection pattern portion 53, for example, by a flying checker (Not illustrated. The same applies hereinafter.).

Here, the flying checker refers to an inspection jig that applies probes (needles that come into contact with or insert into an object to be measured for measurement, experiment, or the like) to determine open/short of a mounted component such as a substrate (Hereinafter referred to as a "checker".).

In the example illustrated in Fig. 4, since wet spreading of the conductive resin 72 does not occur between the terminal 62 and the detection pattern portion 53, a value of the capacitance Cx is substantially zero (0) between the terminal 62 and the detection pattern portion 53.

Similarly, a capacitance Cy is measured between the terminal 62 and the detection pattern portion 51 on the substrate 50. Measurement of the capacitance Cy is performed with the checker by applying measurement probes respectively to the inspection terminal 62a connected to the terminal 62 and the inspection terminal 51a connected to the detection pattern portion 51. In the example illustrated in Fig. 4, since wet spreading of the conductive resin 72 does not occur between the terminal 62 and the detection pattern portion 51, a value of the capacitance Cy is substantially zero (0) between the terminal 62 and the detection pattern portion 51.

Similarly, measurement is performed of a capacitance Cx between the terminal 61 and the detection pattern portion 52 and a capacitance Cy between the terminal 61 and the detection pattern portion 51 on the substrate 50. A method of measuring the capacitances Cx and Cy is similar to the measurement method described above, and thus the description thereof will be omitted.

In the example illustrated in Fig. 4, since wet spreading of the conductive resin 71 does not occur between the terminal 61 and the detection pattern portion 52 and between the terminal 61 and the detection pattern portion 51, both are substantially zero (0) of a value of the capacitance Cx between the terminal 61 and the detection pattern portion 52 and a value of the capacitance Cy between the terminal 61 and the detection pattern portion 51.

Fig. 5 is an explanatory diagram of a partially enlarged view illustrating a bonded state when wet spreading of the conductive resin 72 occurs between the substrate 50 and the Peltier element 20 in the X end view illustrated in Fig. 3. In the example illustrated in Fig. 5, an appropriate amount of the conductive resin 71 is applied between the electrode 21 and the terminal 61. However, a large amount of the conductive resin 72 is applied between the electrode 22 and the terminal 62. For this reason, wet spreading of the conductive resin 72 occurs between the electrode 22 and the terminal 62.

In this state, a capacitance Cx is measured between the terminal 62 and the detection pattern portion 53 on the substrate 50. Measurement of the capacitance Cx is performed similarly to that described with reference to Fig. 4. In the example illustrated in Fig. 5, since wet spreading of the conductive resin 72 occurs between the terminal 62 and the detection pattern portion 53, the value of the capacitance Cx is not zero (0) between the terminal 62 and the detection pattern portion 53.

Specifically, the conductive resin 72 reaches the insulator 53b covering the detection pattern portion 53 due to wet spreading and covers the insulator 53b. As a result, a structure is formed in which the insulator 53b that is a dielectric is sandwiched between the detection pattern portion 53 and the conductive resin 72 that are conductors. As a result, a capacitance C1 is formed between the conductive resin 72 and the detection pattern portion 53.

Thus, when the capacitance Cx is measured between the inspection terminal 62a and the inspection terminal 53a, the capacitance C1 can be obtained that is formed between the conductive resin 72 and the detection pattern portion 53. As a result, it can be known that the conductive resin 72 wet-spreads and reaches the detection pattern portion 53.

Similarly, the capacitance Cy is measured between the terminal 62 and the detection pattern portion 51. Measurement of the capacitance Cy is performed similarly to that described with reference to Fig. 4. In the example illustrated in Fig. 5, since wet spreading of the conductive resin 72 occurs between the terminal 62 and the detection pattern portion 51, the value of the capacitance Cy is not zero (0) between the terminal 62 and the detection pattern portion 51.

That is, the conductive resin 72 reaches the insulator 51b covering the detection pattern portion 51 due to wet spreading and covers the insulator 51b. For this reason, a structure is formed in which the insulator 51b that is a dielectric is sandwiched between the detection pattern portion 51 and the conductive resin 72 that are conductors, and a capacitance C2 is formed between the conductive resin 72 and the detection pattern portion 51.

Thus, when the capacitance Cy is measured between the inspection terminal 62a and the inspection terminal 51a, the capacitance C2 can be obtained that is formed between the conductive resin 72 and the detection pattern portion 51. As a result, it can be known that the conductive resin 72 wet-spreads and reaches the detection pattern portion 51.

Note that, in the example illustrated in Fig. 5, since wet spreading of the conductive resin 71 does not occur between the terminal 61 and the detection pattern portion 52 and between the terminal 61 and the detection pattern portion 51, both are substantially zero (0) of the value of the capacitance Cx between the terminal 61 and the detection pattern portion 52 and the value of the capacitance Cy between the terminal 61 and the detection pattern portion 51.

### <2. Manufacturing Process of First Embodiment of Semiconductor Device according to Present Disclosure>

Next, a description will be given of a manufacturing process of the first embodiment of the semiconductor device 101 according to the present disclosure. Figs. 6 to 14 are explanatory diagrams with the X end view of the manufacturing process of the first embodiment of the semiconductor device 101.

First, as illustrated in Fig. 6, a green sheet 90 is prepared. The green sheet 90 is obtained by mixing a ceramic raw material powder with a binder or the like to form a paste, thinly extending the paste on a plastic carrier film into a sheet, and drying the sheet.

Next, as illustrated in Fig. 7, a paste-like conductive material is printed on the green sheet 90 following shapes of the terminals 61 and 62, the detection pattern portions 51, 52, and 53, and the like. Note that, although not illustrated in the figure, this similarly applies to the inspection terminals 51a, 52a, 53a, 61a, and 62a. Furthermore, the conductive material is, for example, a conductive metallic material such as tungsten (W).

Next, as illustrated in Fig. 8, alumina coating for forming the insulators 51b, 52b, and 53b is applied on the detection pattern portions 51, 52, and 53. In this way, a stacked body including the green sheet 90 is formed.

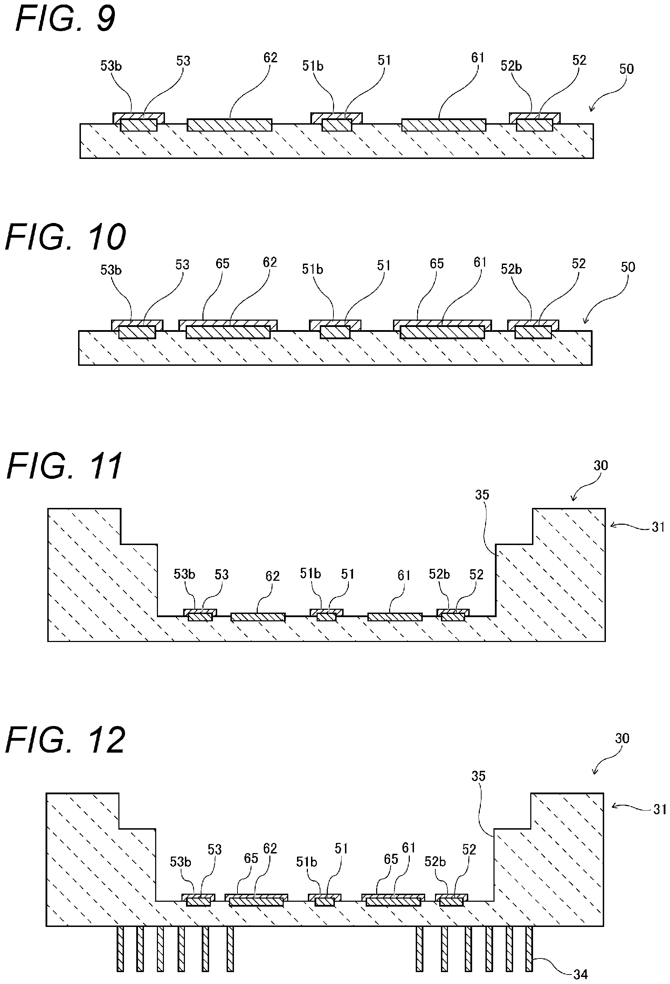

Next, as illustrated in Fig. 9, the stacked body including the green sheet 90 is sintered. As a result, a ceramic material on the green sheet 90 forms the substrate 50 of ceramics. Furthermore, the conductive material on the substrate 50 forms the terminals 61 and 62, the detection pattern portions 51, 52, and 53, and the inspection terminals 51a, 52a, 53a, 61a, and 62a, and the like (not illustrated). Moreover, the alumina coating on the detection pattern portions 51, 52, and 53 forms the insulators 51b, 52b, and 53b including aluminum oxide (Al₂O₃) covering the detection pattern portions 51, 52, and 53 through a sintering process.

Furthermore, the plastic carrier film forming the green sheet 90 is burned down, and the substrate 50 including sintered ceramic, the terminals 61 and 62 and the detection pattern portions 51, 52, and 53 on the substrate 50 remain. Moreover, inspection terminals 51a, 52a, 53a, 61a, and 62a, and the like (not illustrated) remain.

Furthermore, the insulators 51b, 52b, and 53b may include an insulating resin. In this case, a process of forming alumina coating illustrated in Fig. 8 is unnecessary. Instead, it is only required to provide a process of forming an insulating resin on upper surfaces of the detection pattern portions 51, 52, and 53.

Note that the sintering process illustrated in Fig. 9 is not actually performed in a state where the stacked body including one green sheet 90 as illustrated in Fig. 8 described above is a single body, but is performed in a state where stacking is performed on a package frame body 31 illustrated in Fig. 11 described later. That is, the package frame body 31 is formed by sequentially stacking a plurality of green sheets 90 of a plurality of types. Thus, the stacked body including the green sheet 90 illustrated in Fig. 8 is stacked together with other green sheets 90 when the plurality of green sheets 90 of the plurality of types is sequentially stacked to form the package frame body 31. Then, after the stacking, the package frame body 31 formed is sintered, whereby the substrate 50 illustrated in Fig. 9 is also formed in the cavity 35 of the package frame body 31.

Next, as illustrated in Fig. 10, plating treatment is performed on the terminals 61 and 62 and the inspection terminals 51a, 52a, 53a, 61a, and 62a formed by sintering with a conductive metal 65 such as gold (Au). That is, conductor portions such as the terminals 61 and 62 including tungsten (W) or the like formed by sintering are covered with the conductive metal 65 such as gold (Au). Note that, similarly to the process in Fig. 9, the plating treatment is actually performed in a plating process for the entire package frame body 31 illustrated in Fig. 12 described later.

Next, an example of forming the package frame body 31 will be specifically described. Among the plurality of green sheets 90 forming the package frame body 31, in the green sheet 90 forming the cavity 35, a square hole to be the cavity 35, a small hole to be the via 31c, and the like are drilled by punching or the like. Furthermore, on the green sheet 90 to be a wiring layer, a predetermined conductive material is printed following a shape of a pattern of the wiring line 31b. Similarly, on the green sheet 90 on which the pin 34 is to be vertically provided, a predetermined conductive material is printed following a shape of a pattern of the pad 31d. Furthermore, in the green sheet 90 for securing a thickness, a small hole or the like to be the via 31c is drilled. Then, the plurality of green sheets 90 of the plurality of types is sequentially stacked in a predetermined order so as to have a predetermined thickness.

In such a stacking process, the stacked body including the green sheet 90 formed in the process illustrated in Fig. 8 is stacked at a position that is the uppermost surface of the bottom portion of the cavity 35.

The plurality of green sheets 90 of the plurality of types stacked as described above is formed into the predetermined package frame body 31. Then, the package frame body 31 formed is sintered. As a result, the package frame body 31 as illustrated in Fig. 11 is formed. In the cavity 35, the connection terminal 31a, the wiring line 31b, the via 31c, the pad 31d, and the like are formed for connecting to the semiconductor element 10 described with reference to Fig. 3 by wire bonding or the like (all are not illustrated in the figure). Furthermore, the terminals 61 and 62, the detection pattern portions 51, 52, and 53, the insulators 51b, 52b, and 53b, and the like described in Fig. 9 are formed on the substrate 50 that is the bottom portion of the cavity 35.

Next, as illustrated in Fig. 12, the predetermined plurality of metal pins 34 for supplying power to the semiconductor element 10 and the Peltier element 20 and inputting and outputting signals from and to external devices is each vertically provided on the pad 31d formed on the lower surface of the package frame body 31 by brazing or the like. Then, predetermined plating treatment or the like is performed.

In this process, as described above with reference to Fig. 10, the conductor portions such as the terminals 61 and 62 are also covered with the conductive metal 65 such as gold (Au).

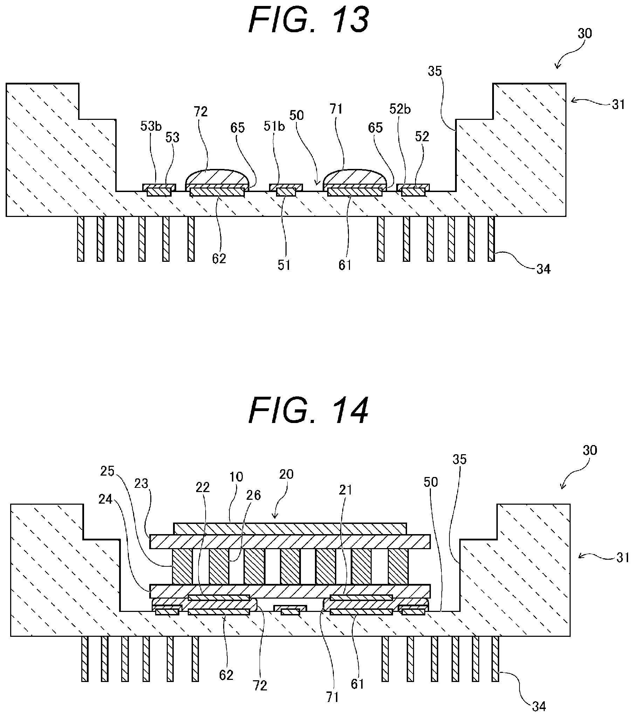

Next, as illustrated in Fig. 13, appropriate amounts of conductive resins 71 and 72 are applied to the upper surfaces of the terminals 61 and 62, respectively.

Next, as illustrated in Fig. 14, the Peltier element 20 to which the semiconductor element 10 is bonded is placed on the upper surfaces of the applied conductive resins 71 and 72, and both are bonded together to thermally cure the conductive resins 71 and 72. As a result, the electrodes 21 and 22 and the terminals 61 and 62 are electrically connected to each other through the conductive resins 71 and 72, respectively. When the bonding by thermal curing is completed, the capacitances Cx and Cy are measured by the method described above with reference to Figs. 4 and 5 by using the checker, and a wet spreading inspection of the conductive resins 71 and 72 is performed.

As a result of the inspection, in a case where the values of the capacitances Cx and Cy are both substantially zero (0), the semiconductor device is determined as a good product, and sent to the next process. In a case where the values of the capacitances Cx and Cy are not substantially zero (0), the semiconductor device is determined as a defective product, and sent to a process of processing the defective product. Hereinafter, a similar procedure is performed in manufacturing processes of other embodiments.

By having the manufacturing process as described above, it is possible to manufacture the semiconductor device 101 of the first embodiment according to the present disclosure as illustrated in Figs. 2 and 3 through an assembly process, a final inspection process, and the like after that.

### [Effects of First Embodiment]

Since the first embodiment of the semiconductor device 101 according to the present disclosure is configured as described above, it is possible to simply and quickly perform the inspection of bonding between the Peltier element 20 that is a cooling device for the semiconductor element 10 and the substrate 50 by using a simple checker.

### <3. Second Embodiment of Semiconductor Device according to Present Disclosure>

### [Basic Configuration of Second Embodiment]

Next, a description will be given of a second embodiment of the semiconductor device 101 according to the present disclosure.

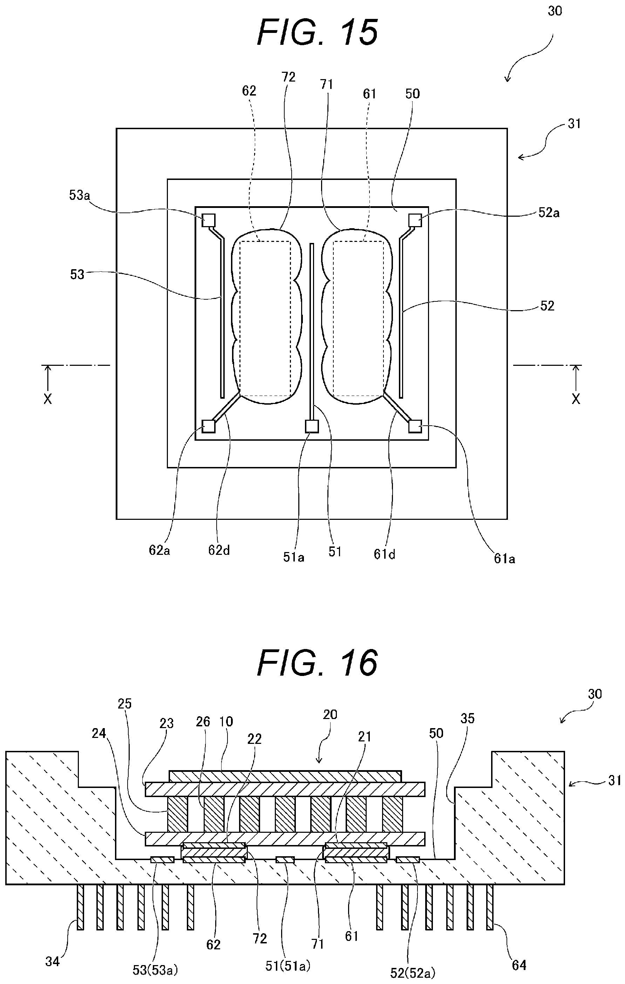

Fig. 15 is a plan view of the PGA package 30 before the Peltier element 20 is bonded to the substrate 50 in the second embodiment.

In the second embodiment, as illustrated in the figure, arrangement of the terminals 61 and 62, the detection pattern portions 51, 52, and 53, and the inspection terminals 51a, 52a, 53a, 61a, and 62a is similar to that in the case of the first embodiment illustrated in Fig. 2.

However, in the second embodiment, as illustrated in Figs. 15 to 18, the detection pattern portions 51, 52, and 53 are not covered with the insulators 51b, 52b, and 53b, respectively, as in the first embodiment. That is, in the second embodiment, the detection pattern portions 51, 52, and 53 are not covered with the insulators 51b, 52b, and 53b, respectively, and are plated with the conductive metal 65 such as gold (Au) to expose conductor portions, for example.

Other than the above, the configuration is similar to that of the first embodiment, and thus the description thereof will be omitted.

### [Wet Spreading Inspection Method of Second Embodiment]

Next, a description will be given below of an inspection method for detecting wet spreading of the conductive resins 71 and 72 by the inspection terminals 51a, 52a, and 53a connected to the detection pattern portions 51, 52, and 53 and the inspection terminals 61a and 62a connected to the terminals 61 and 62.

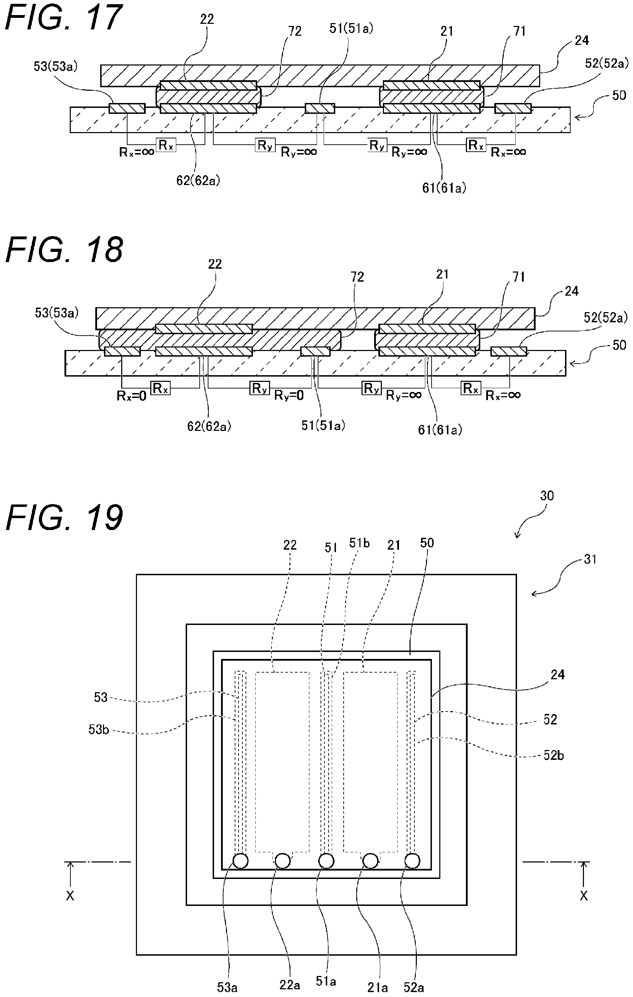

Fig. 17 is a partially enlarged explanatory diagram illustrating a bonded state when wet spreading of the conductive resins 71 and 72 does not occur between the substrate 50 and the Peltier element 20 in the X end view illustrated in Fig. 16. In the example illustrated in Fig. 17, an appropriate amount of the conductive resin 72 is applied between the electrode 22 and the terminal 62. Similarly, an appropriate amount of the conductive resin 72 is also applied between the electrode 21 and the terminal 61. For this reason, as illustrated in the figure, wet spreading of the conductive resins 71 and 72 does not occur between the electrode 22 and the terminal 62 and between the electrode 21 and the terminal 61.

In this state, a resistance Rx is measured between the terminal 62 and the detection pattern portion 53 on the substrate 50. Measurement of the resistance Rx is performed with the checker by applying measurement probes respectively to the inspection terminal 62a connected to the terminal 62 and the inspection terminal 53a connected to the detection pattern portion 53. In the example illustrated in Fig. 17, since wet spreading of the conductive resin 72 does not occur between the terminal 62 and the detection pattern portion 53, a value of the resistance Rx is substantially infinite (∞) between the terminal 62 and the detection pattern portion 53.

Similarly, the resistance Ry is measured between the terminal 62 on the substrate 50 and the detection pattern portion 51. Measurement of the resistance Ry is performed with the checker by applying measurement probes respectively to the inspection terminal 62a connected to the terminal 62 and the inspection terminal 51a connected to the detection pattern portion 51. In the example illustrated in Fig. 17, since wet spreading of the conductive resin 72 does not occur between the terminal 62 and the detection pattern portion 51, a value of the resistance Ry is substantially infinite (∞) between the terminal 62 and the detection pattern portion 51.

Similarly, measurement is performed of a resistance Rx between the terminal 61 and the detection pattern portion 52 and a resistance Ry between the terminal 61 and the detection pattern portion 51 on the substrate 50. A method of measuring the resistance Rx and Ry is similar to the measurement method described above, and thus the description thereof will be omitted.

In the example illustrated in Fig. 17, since wet spreading of the conductive resin 71 does not occur between the terminal 61 and the detection pattern portion 52 and between the terminal 61 and the detection pattern portion 51, both are substantially infinite (∞) of a value of the resistance Rx between the terminal 61 and the detection pattern portion 52 and a value of the resistance Ry between the terminal 61 and the detection pattern portion 51.

Fig. 18 is an explanatory diagram of a partially enlarged view illustrating a bonded state when wet spreading of the conductive resin 72 occurs between the substrate 50 and the Peltier element 20 in the X end view illustrated in Fig. 16. In the example illustrated in Fig. 18, an appropriate amount of the conductive resin 71 is applied between the electrode 21 and the terminal 61. However, a large amount of the conductive resin 72 is applied between the electrode 22 and the terminal 62. For this reason, wet spreading of the conductive resin 72 occurs between the electrode 22 and the terminal 62.

In this state, a resistance Rx is measured between the terminal 62 and the detection pattern portion 53 on the substrate 50. Measurement of the resistance Rx is performed similarly to that described with reference to Fig. 17. In the example illustrated in Fig. 18, since wet spreading of the conductive resin 72 occurs between the terminal 62 and the detection pattern portion 53, the value of the resistance Rx is not infinite (∞) between the terminal 62 and the detection pattern portion 53.

Specifically, the conductive resin 72 reaches the detection pattern portion 53 due to wet spreading. However, the detection pattern portion 53 is not covered with the insulator 53b, and the conductor portion is exposed. Thus, the conductive resin 72 and the detection pattern portion 53 are electrically connected to each other, and are in a so-called short-circuited state.

For this reason, when the resistance Rx between the inspection terminal 62a and the inspection terminal 53a is measured, a value of the resistance Rx between the conductive resin 72 and the detection pattern portion 53 is substantially zero ohms (0 Ω). As a result, it can be known that the conductive resin 72 wet-spreads and reaches the detection pattern portion 53.

Similarly, the resistance Ry is measured between the terminal 62 and the detection pattern portion 51. Measurement of the resistance Ry is performed similarly to that described with reference to Fig. 17. In the example illustrated in Fig. 18, since wet spreading of the conductive resin 72 occurs between the terminal 62 and the detection pattern portion 51, similarly, a value of the resistance Ry is substantially zero ohms (0 Q) between the terminal 62 and the detection pattern portion 51.

That is, the conductive resin 72 reaches the detection pattern portion 51 due to wet spreading and causes a short circuit. As a result, it can be known that the conductive resin 72 wet-spreads and reaches the detection pattern portion 51.

Note that, in the example illustrated in Fig. 18, since wet spreading of the conductive resin 71 does not occur between the terminal 61 and the detection pattern portion 52 and between the terminal 61 and the detection pattern portion 51, both are substantially infinite (∞) of a value of the resistance Rx between the terminal 61 and the detection pattern portion 52 and a value of the resistance Ry between the terminal 61 and the detection pattern portion 51.

### [Manufacturing Process of Second Embodiment]

In the manufacturing process of the second embodiment of the semiconductor device 101, it is not necessary to apply alumina coating for forming the insulators 51b, 52b, and 53b on the detection pattern portions 51, 52, and 53 as illustrated in Fig. 8. That is, in the manufacturing process of the second embodiment, the process illustrated in Fig. 8 is unnecessary. Note that, the detection pattern portions 51, 52, and 53 may be plated with the conductive metal 65 such as gold (Au) in the plating treatment process illustrated in Fig. 10.

Other than the above, the manufacturing process is similar to that described with reference to Figs. 6 to 14, and thus the description thereof will be omitted.

### [Effects of Second Embodiment]

Since the second embodiment of the semiconductor device 101 according to the present disclosure is configured as described above, a process is unnecessary of applying alumina coating for forming the insulators 51b, 52, and 53b on the detection pattern portions 51, 52, and 53 illustrated in Fig. 8. Furthermore, it is possible to simply and quickly perform the inspection of bonding between the Peltier element 20 and the substrate 50 by using a simple checker.

Moreover, since the wet spreading inspection of the conductive resins 71 and 72 can be achieved by simply measuring the resistance, it is not necessary to use expensive inspection equipment, a simple checker for conduction inspection is sufficient, and an investment amount of the inspection equipment is small.

### <4. Third Embodiment of Semiconductor Device according to Present Disclosure>

### [Basic Configuration of Third Embodiment]

Next, a description will be given of a third embodiment of the semiconductor device 101 according to the present disclosure.

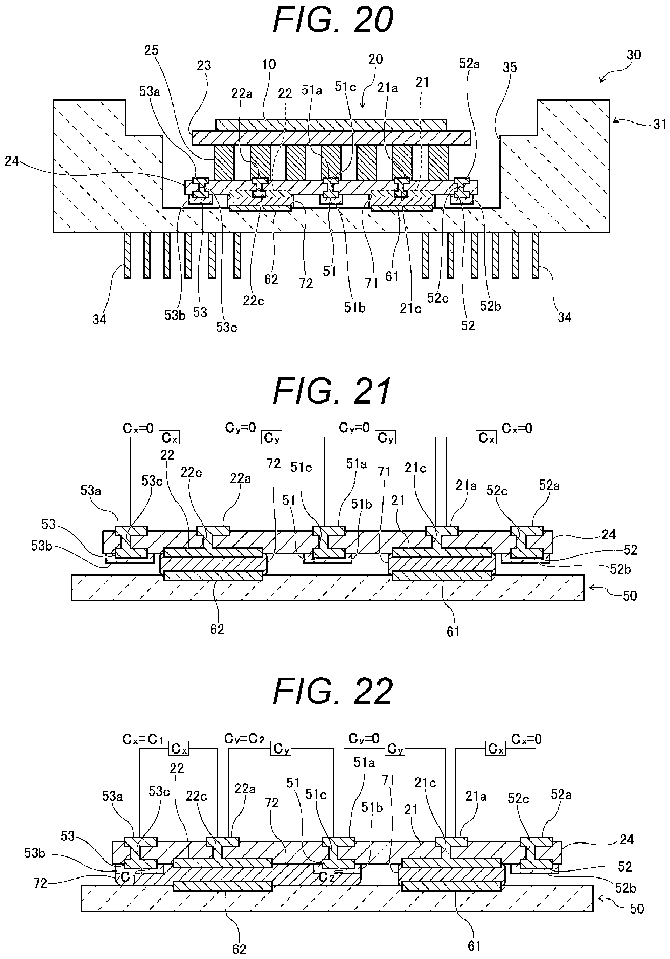

Fig. 19 is a plan view of the PGA package 30 in a plan view of the heat dissipation plate 24 of the Peltier element 20 in a state where the Peltier element 20 is bonded to the substrate 50 in the third embodiment. Furthermore, Fig. 20 is an X end view of Fig. 19.

In the third embodiment, as illustrated in Fig. 20, the heat dissipation plate 24 is formed to be wider than the heat absorption plate 23, and a peripheral edge thereof protrudes more than the heat absorption plate 23.

Furthermore, as illustrated in Fig. 19, the terminals 61 and 62 are disposed on the substrate 50, but the detection pattern portions 51, 52, and 53 and the inspection terminals 51a, 52a, 53a, 61a, and 62a are not disposed.

As illustrated in Figs. 19 and 20, these detection pattern portions 51, 52, and 53 are disposed on a lower surface of the heat dissipation plate 24 that is the heat dissipation portion of the Peltier element 20. Furthermore, the inspection terminals 51a, 52a, 53a, 21a, and 22a are disposed on an upper surface of the heat dissipation plate 24.

Then, the detection pattern portions 51, 52, and 53 disposed on the lower surface of the heat dissipation plate 24 and the inspection terminals 51a, 52a, and 53a disposed on the upper surface of the heat dissipation plate 24 are connected to each other via through holes 51c, 52c, and 53c, respectively. Similarly, the electrodes 21 and 22 and the inspection terminals 21a and 22a are connected to each other via the through holes 21c and 22c, respectively.

Specifically, as illustrated in Figs. 19 to 22, one ends of the detection pattern portions 51, 52, and 53 disposed on the lower surface of the heat dissipation plate 24 are connected to lower ends of the through holes 51c, 52c, and 53c, respectively. Furthermore, upper ends of the through holes 51c, 52c, and 53c are connected to the inspection terminals 51a, 52a, and 53a disposed on the upper surface of the heat dissipation plate 24, respectively. As a result, the detection pattern portions 51, 52, and 53 disposed on the lower surface of the heat dissipation plate 24 are electrically connected to the inspection terminals 51a, 52a, and 53a disposed on the upper surface of the heat dissipation plate 24, respectively.

Note that, the electrodes 21 and 22, the detection pattern portions 51, 52, and 53, the through holes 51c, 52c, and 53c, and the inspection terminals 51a, 52a, 53a, 21a, and 22a are each electrically insulated from the heat dissipation plate 24 in a predetermined manner (the same applies hereinafter).

Other than the above, the configuration is similar to that in the case of Figs. 2 and 3 in the first embodiment, and thus the description thereof will be omitted.

### [Wet Spreading Inspection Method of Third Embodiment]

Next, a description will be given below of an inspection method for detecting wet spreading of the conductive resins 71 and 72 by the inspection terminals 51a, 52a, and 53a connected to the detection pattern portions 51, 52, and 53 and the inspection terminals 61a and 62a connected to the terminals 61 and 62.

Fig. 21 is a partially enlarged explanatory diagram illustrating a bonded state when wet spreading of the conductive resins 71 and 72 does not occur between the substrate 50 and the Peltier element 20 in the X end view illustrated in Fig. 20. An appropriate amount of the conductive resin 72 is applied between the electrode 22 and the terminal 62. Similarly, an appropriate amount of the conductive resin 72 is also applied between the electrode 21 and the terminal 61. For this reason, wet spreading of the conductive resins 71 and 72 does not occur between the electrode 22 and the terminal 62 and between the electrode 21 and the terminal 61.

In this state, a capacitance Cx is measured between the electrode 22 and the detection pattern portion 53 on the lower surface of the heat dissipation plate 24. Measurement of the capacitance Cx is performed with the inspection terminal 22a and the inspection terminal 53a disposed on the upper surface of the heat dissipation plate 24. Other than the above, the method is similar to that in the case of Fig. 4 in the first embodiment described above, and thus the description thereof will be omitted. In this case, a value of the capacitance Cx is substantially zero (0) between the electrode 22 and the detection pattern portion 53.

Similarly, a capacitance Cy is measured between the electrode 22 and the detection pattern portion 51 on the lower surface of the heat dissipation plate 24. In this case, a value of the capacitance Cy is substantially zero (0).

Similarly, measurement is performed of a capacitance Cx between the electrode 21 and the detection pattern portion 52 and a capacitance Cy between the electrode 21 and the detection pattern portion 51. In this case, both are substantially zero (0) of a value of the capacitance Cx and a value of the capacitance Cy.

Fig. 22 is an explanatory diagram of a partially enlarged view illustrating a bonded state when wet spreading of the conductive resin 72 occurs between the substrate 50 and the Peltier element 20 in the X end view illustrated in Fig. 20. An appropriate amount of the conductive resin 71 is applied between the electrode 21 and the terminal 61. However, a large amount of the conductive resin 72 is applied between the electrode 22 and the terminal 62. For this reason, wet spreading of the conductive resin 72 occurs between the electrode 22 and the terminal 62.

In this state, the capacitance Cx is measured between the electrode 22 and the detection pattern portion 53 on the lower surface of the heat dissipation plate 24. Since the method of measuring the capacitance Cx is similar to that in the case of Fig. 5 in the first embodiment described above, the description thereof will be omitted. In this case, the value of the capacitance Cx is not zero (0) between the electrode 22 and the detection pattern portion 53, but is the capacitance C1 as in the case of Fig. 5 in the first embodiment described above. As a result, it can be known that the conductive resin 72 wet-spreads and reaches the detection pattern portion 53.

Similarly, the capacitance Cy is measured between the electrode 22 and the detection pattern portion 51. In the example illustrated in Fig. 22, since wet spreading of the conductive resin 72 occurs between the electrode 22 and the detection pattern portion 51, a value of the capacitance Cy is not zero (0) between the electrode 22 and the detection pattern portion 51, but is the capacitance C2 as in the case of Fig. 5 in the first embodiment described above. As a result, it can be known that the conductive resin 72 wet-spreads and reaches the detection pattern portion 51.

Note that, in the example illustrated in Fig. 22, since wet spreading of the conductive resin 71 does not occur between the electrode 21 and the detection pattern portion 52 and between the electrode 21 and the detection pattern portion 51, both are substantially zero (0) of a value of the capacitance Cx between the electrode 21 and the detection pattern portion 52 and a value of the capacitance Cy between the electrode 21 and the detection pattern portion 51.

### [Manufacturing Process of Third Embodiment]

In the manufacturing process of the third embodiment of the semiconductor device 101, it is not necessary to form the detection pattern portions 51, 52, and 53, the insulators 51b, 52b, and 53b, and the inspection terminals 61a and 62a (not illustrated) on the green sheet 90 as illustrated in Figs. 6 to 10. For this reason, the process of applying the alumina coating illustrated in Fig. 8 is unnecessary in the manufacturing process of the third embodiment.

Note that, a process of forming the detection pattern portions 51, 52, and 53 on the lower surface of the heat dissipation plate 24 of the Peltier element 20 and covering them with the insulators 51b, 52b, and 53b, respectively, is performed in a manufacturing process (not illustrated) of the Peltier element 20.

Similarly, a process of forming the inspection terminals 51a, 52a, 53a, 21a, and 22a on the upper surface of the heat dissipation plate 24 and connecting them to the detection pattern portions 51, 52, and 53 and the electrodes 21 and 22 via the through holes 51c, 52c, 53c, 21c, and 22c, respectively, is also performed in the manufacturing process (not illustrated) of the Peltier element 20. The Peltier element 20 thus manufactured is bonded to the substrate 50 in the process illustrated in Fig. 14.

Other than the above, the manufacturing process is similar to that described with reference to Figs. 6 to 14, and thus the description thereof will be omitted.

### [Effects of Third Embodiment]

Since the third embodiment of the semiconductor device 101 according to the present disclosure is configured as described above, processes are unnecessary of forming the detection pattern portions 51, 52, and 53, the insulators 51b, 52b, and 53b, and the inspection terminals 61a and 62a (not illustrated) in Figs. 7 to 10. For this reason, the process of applying the alumina coating illustrated in Fig. 8 is unnecessary.

Furthermore, since the inspection terminals 51a, 52a, 53a, 21a, and 22a are disposed on a peripheral edge of the upper surface of the heat dissipation plate 24 disposed at the upper side of the substrate 50, checker probes can be easily applied, and workability can be improved.

The effects of the third embodiment of the semiconductor device 101 other than the above are similar to those of the first embodiment, and thus the description thereof will be omitted.

### <5. Fourth Embodiment of Semiconductor Device according to Present

### Disclosure>

### [Basic Configuration of Fourth Embodiment]

Next, a description will be given of a fourth embodiment of the semiconductor device 101 according to the present disclosure.

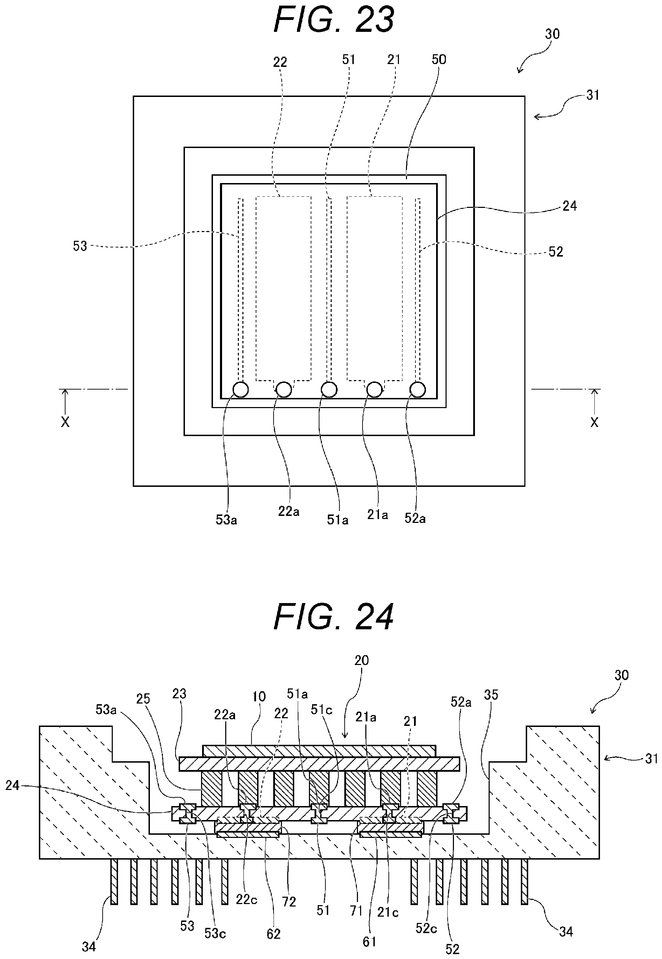

Fig. 23 is a plan view of the PGA package 30 in a plan view of the heat dissipation plate 24 of the Peltier element 20 in a state where the Peltier element 20 is bonded to the substrate 50 in the fourth embodiment. Furthermore, Fig. 24 is an X end view of Fig. 23.

In the fourth embodiment, as illustrated in Fig. 23, arrangement of the terminals 61 and 62 and the electrodes 21 and 22 is similar to that in the case of the third embodiment illustrated in Figs. 19 and 20. Furthermore, as illustrated in Fig. 23, arrangement and connection of the detection pattern portions 51, 52, and 53 and the inspection terminals 51a, 52a, 53a, 21a, and 22a are similar to those in the case of the third embodiment illustrated in Fig. 19. Furthermore, the heat dissipation plate 24 is formed to be wider than the heat absorption plate 23, and the peripheral edge protrudes more than the heat absorption plate 23, which is similar to the case of the third embodiment.

However, in the fourth embodiment, as illustrated in Figs. 23 to 26, the detection pattern portions 51, 52, and 53 are not covered with the insulators 51b, 52b, and 53b, respectively, as in the second embodiment. That is, in the fourth embodiment, the detection pattern portions 51, 52, and 53 are not covered with the insulators 51b, 52b, and 53b, respectively, and conductor portions are exposed, which are plated with the conductive metal 65 such as tungsten (W) or gold (Au), for example.

Other than the above, the configuration is similar to that in the case of Figs. 19 to 22 in the third embodiment, and thus the description thereof will be omitted.

### [Wet Spreading Inspection Method of Fourth Embodiment]

Next, a description will be given below of an inspection method for detecting wet spreading of the conductive resins 71 and 72 by the inspection terminals 51a, 52a, and 53a connected to the detection pattern portions 51, 52, and 53 and the inspection terminals 21a and 22a connected to the electrodes 21 and 22.

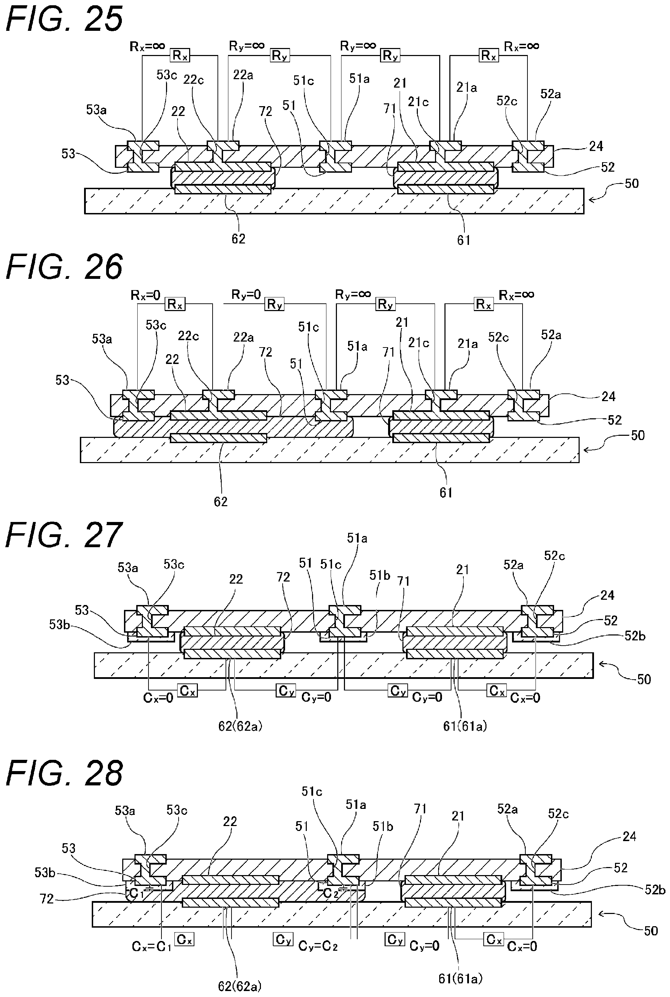

Fig. 25 is a partially enlarged explanatory diagram illustrating a bonded state when wet spreading of the conductive resins 71 and 72 does not occur between the substrate 50 and the Peltier element 20 in the X end view illustrated in Fig. 24.

In this state, a method of measuring a resistance Rx between the electrode 22 and the detection pattern portion 53 on the lower surface of the heat dissipation plate 24 and a method of measuring a resistance Ry between the electrode 22 and the detection pattern portion 51 are similar to those in the case of Fig. 21 in the third embodiment, and thus, the description thereof will be omitted. In this case, a value of the resistance Rx and a value of the resistance Ry are both substantially infinite (∞).

Similarly, measurement is performed of a resistance Rx between the electrode 21 and the detection pattern portion 52 and a resistance Ry between the electrode 21 and the detection pattern portion 51. In this case, a value of the resistance Rx and a value of the resistance Ry are both substantially infinite (∞).

Fig. 26 is an explanatory diagram of a partially enlarged view illustrating a bonded state when wet spreading of the conductive resin 72 occurs between the substrate 50 and the Peltier element 20 in the X end view illustrated in Fig. 24.

In this state, the method of measuring the resistance Rx between the electrode 22 and the detection pattern portion 53 on the lower surface of the heat dissipation plate 24 is similar to that in the case of Fig. 22 in the third embodiment, and thus the description thereof will be omitted. In this case, the electrode 22 and the detection pattern portion 53 are electrically connected to each other due to wet spreading of the conductive resin 72, and are in a so-called short-circuited state. For this reason, a value of the resistance Rx between the electrode 22 and the detection pattern portion 53 is substantially zero ohms (0 Ω). As a result, it can be known that the conductive resin 72 wet-spreads and reaches the detection pattern portion 53.

Similarly, the method of measuring the resistance Ry between the electrode 22 and the detection pattern portion 51 is similar to that in the case of Fig. 22 in the third embodiment, and thus the description thereof will be omitted. In this case, since the electrode 22 and the detection pattern portion 51 are short-circuited, the value of the resistance Ry is substantially zero ohms (0 Ω). As a result, it can be known that the conductive resin 72 wet-spreads and reaches the detection pattern portion 51.

Note that, in the example illustrated in Fig. 26, since wet spreading of the conductive resin 71 does not occur between the electrode 21 and the detection pattern portion 52 and between the electrode 21 and the detection pattern portion 51, both are substantially infinite (∞) of a value of the resistance Rx between the electrode 21 and the detection pattern portion 52 and a value of the resistance Ry between the electrode 21 and the detection pattern portion 51.

### [Manufacturing Process of Fourth Embodiment]

In the manufacturing process of the fourth embodiment of the semiconductor device 101, the processes illustrated in Figs. 7 to 10 are similar to those in the manufacturing process of the third embodiment, and thus the description thereof will be omitted.

Furthermore, in the process of forming the detection pattern portions 51, 52, and 53 and the like on the lower surface of the heat dissipation plate 24 of the Peltier element 20, the process of covering the detection pattern portions 51, 52, and 53 with the insulators 51b, 52b, 53b is unnecessary. Other than the above, processes are similar to those in the manufacturing process of the third embodiment, and thus the description thereof will be omitted.

### [Effects of Fourth Embodiment]

Since the fourth embodiment of the semiconductor device 101 according to the present disclosure is configured as described above, the processes are unnecessary of forming the detection pattern portions 51, 52, and 53 and the insulators 51b, 52b, and 53b in Figs. 7 to 10, and of applying the alumina coating illustrated in Fig. 8.

Moreover, since the wet spreading inspection of the conductive resins 71 and 72 can be achieved by simply measuring the resistance, it is not necessary to use expensive inspection equipment, a simple checker for conduction inspection is sufficient, and an investment amount of the inspection equipment is small.

The effects of the fourth embodiment of the semiconductor device 101 other than the above are similar to those of the third embodiment, and thus the description thereof will be omitted.

<6. Fifth Embodiment of Semiconductor Device according to Present Disclosure>

### [Basic Configuration of Fifth Embodiment]

Next, a description will be given of a fifth embodiment of the semiconductor device 101 according to the present disclosure.

In the fifth embodiment, in the heat dissipation plate 24 in the third embodiment, the inspection terminals 21a and 22a connected to the electrodes 21 and 22 are not provided, and similarly to the first embodiment, the inspection terminals 61a and 62a are provided to the terminals 61 and 62 on the substrate 50. That is, the fifth embodiment has a compromise structure between the third embodiment and the first embodiment.

Thus, in the fifth embodiment, as illustrated in Fig. 27, the inspection terminals 61a and 62a are connected to the terminals 61 and 62 disposed on the substrate 50, respectively. Furthermore, detection pattern portions 51, 52, and 53 are disposed on the heat dissipation plate 24, and detection pattern portions 51, 52, and 53 are covered with insulators 51b, 52b, and 53b, respectively. Then, the detection pattern portions 51, 52, and 53 are electrically connected to the inspection terminals 51a, 52a, and 53a disposed on the upper surface of the heat dissipation plate 24 via the through holes 51c, 52c, and 53c, respectively.

Other than the above, the configuration is similar to that described in the first embodiment.

Thus, capacitances Cx are measured between the inspection terminal 62a and the inspection terminal 53a and between the inspection terminal 61a and the inspection terminal 52a. Furthermore, capacitances Cy are measured between the inspection terminal 62a and the inspection terminal 51a and between the inspection terminal 61a and the inspection terminal 51a.

### [Wet Spreading Inspection Method of Fifth Embodiment]

Next, a description will be given below of an inspection method for detecting wet spreading of the conductive resins 71 and 72 by the inspection terminals 51a, 52a, and 53a connected to the detection pattern portions 51, 52, and 53 and the inspection terminals 61a and 62a connected to the terminals 61 and 62.

Fig. 27 is a partially enlarged explanatory diagram illustrating a bonded state when wet spreading of the conductive resins 71 and 72 does not occur between the substrate 50 and the Peltier element 20. An appropriate amount of the conductive resin 72 is applied between the electrode 22 and the terminal 62. Similarly, an appropriate amount of the conductive resin 72 is also applied between the electrode 21 and the terminal 61. For this reason, wet spreading of the conductive resins 71 and 72 does not occur between the electrode 22 and the terminal 62 and between the electrode 21 and the terminal 61.

In this state, the capacitance Cx is measured between the terminal 62 on the substrate 50 and the detection pattern portion 53 on the lower surface of the heat dissipation plate 24. Measurement of the capacitance Cx is performed with the inspection terminal 62a disposed on the upper surface of the substrate 50 and the inspection terminal 53a disposed on the upper surface of the heat dissipation plate 24. Other than the above, the method is similar to that in the case of Fig. 4 in the first embodiment or the case of Fig. 21 in the third embodiment, and thus the description thereof will be omitted. In this case, a value of the capacitance Cx is substantially zero (0) between the terminal 62 and the detection pattern portion 53.

Similarly, the capacitance Cy is measured between the terminal 62 on the substrate 50 and the detection pattern portion 51 on the lower surface of the heat dissipation plate 24. In this case, a value of the capacitance Cy is substantially zero (0).

Similarly, measurement is performed of the capacitance Cx between the terminal 61 and the detection pattern portion 52 and the capacitance Cy between the terminal 61 and the detection pattern portion 51. In this case, both are substantially zero (0) of a value of the capacitance Cx and a value of the capacitance Cy.

Fig. 28 is a partially enlarged explanatory diagram illustrating a bonded state when wet spreading of the conductive resin 72 occurs between the substrate 50 and the Peltier element 20. An appropriate amount of the conductive resin 71 is applied between the electrode 21 and the terminal 61. However, a large amount of the conductive resin 72 is applied between the electrode 22 and the terminal 62. For this reason, wet spreading of the conductive resin 72 occurs between the electrode 22 and the terminal 62.

In this state, the capacitance Cx is measured between the terminal 62 on the substrate 50 and the detection pattern portion 53 on the lower surface of the heat dissipation plate 24. Since the method of measuring the capacitance Cx is similar to that in the case of Fig. 5 in the first embodiment described above, the description thereof will be omitted. In this case, the value of the capacitance Cx is not zero (0) between the terminal 62 and the detection pattern portion 53, but is the capacitance C1 as in the case of Fig. 5 in the first embodiment. As a result, it can be known that the conductive resin 72 wet-spreads and reaches the detection pattern portion 53.

Similarly, the capacitance Cy is measured between the terminal 62 and the detection pattern portion 51. In the example illustrated in Fig. 28, since wet spreading of the conductive resin 72 occurs between the terminal 62 and the detection pattern portion 51, a value of the capacitance Cy is not zero (0) between the terminal 62 and the detection pattern portion 51, but is the capacitance C2 as in the case of Fig. 5 in the first embodiment described above. As a result, it can be known that the conductive resin 72 wet-spreads and reaches the detection pattern portion 51.

Note that, in the example illustrated in Fig. 28, since wet spreading of the conductive resin 71 does not occur between the terminal 61 and the detection pattern portion 52 and between the terminal 61 and the detection pattern portion 51, both are substantially zero (0) of the value of the capacitance Cx between the terminal 61 and the detection pattern portion 52 and the value of the capacitance Cy between the terminal 61 and the detection pattern portion 51.

### [Manufacturing Process of Fifth Embodiment]

In the manufacturing process of the fifth embodiment of the semiconductor device 101, the processes are unnecessary of forming the detection pattern portions 51, 52, and 53 and the insulators 51b, 52b, and 53b on the green sheet 90 as illustrated in Figs. 7 to 10. For this reason, the process of applying the alumina coating illustrated in Fig. 8 is also unnecessary.

Note that, a process of forming the detection pattern portions 51, 52, and 53 on the lower surface of the heat dissipation plate 24 of the Peltier element 20 and covering them with the insulators 51b, 52b, and 53b, respectively, is performed in a manufacturing process (not illustrated) of the Peltier element 20.

Similarly, a process of forming the inspection terminals 51a, 52a, and 53a on the upper surface of the heat dissipation plate 24 and connecting them to the detection pattern portions 51, 52, and 53 via the through holes 51c, 52c, and 53c, respectively, is also performed in the manufacturing process (not illustrated) of the Peltier element 20.

Other than the above, the manufacturing process is similar to that described with reference to Figs. 6 to 14, and thus the description thereof will be omitted.

### [Effects of Fifth Embodiment]

Since the third embodiment of the semiconductor device 101 according to the present disclosure is configured as described above, the processes are unnecessary of forming the detection pattern portions 51, 52, and 53 and the insulators 51b, 52b, and 53b on the green sheet 90 in Figs. 7 to 10. Furthermore, the process of applying the alumina coating illustrated in Fig. 8 is unnecessary.

The effects of the fifth embodiment of the semiconductor device 101 other than the above are similar to those of the first embodiment, and thus the description thereof will be omitted.

### <7. Sixth Embodiment of Semiconductor Device according to Present Disclosure>

### [Basic Configuration of Sixth Embodiment]

Next, a description will be given of a sixth embodiment of the semiconductor device 101 according to the present disclosure.

In the sixth embodiment, the detection pattern portions 51, 52, and 53 in the fifth embodiment are not covered with the insulators 51b, 52b, and 53b, respectively.

Other than the above, the configuration is similar to that described in Figs. 27 and 28 of the fifth embodiment, and thus the description thereof is omitted.

### [Wet Spreading Inspection Method of Sixth Embodiment]

Next, a description will be given below of an inspection method for detecting wet spreading of the conductive resins 71 and 72 by the inspection terminals 51a, 52a, and 53a connected to the detection pattern portions 51, 52, and 53 and the inspection terminals 61a and 62a connected to the terminals 61 and 62.

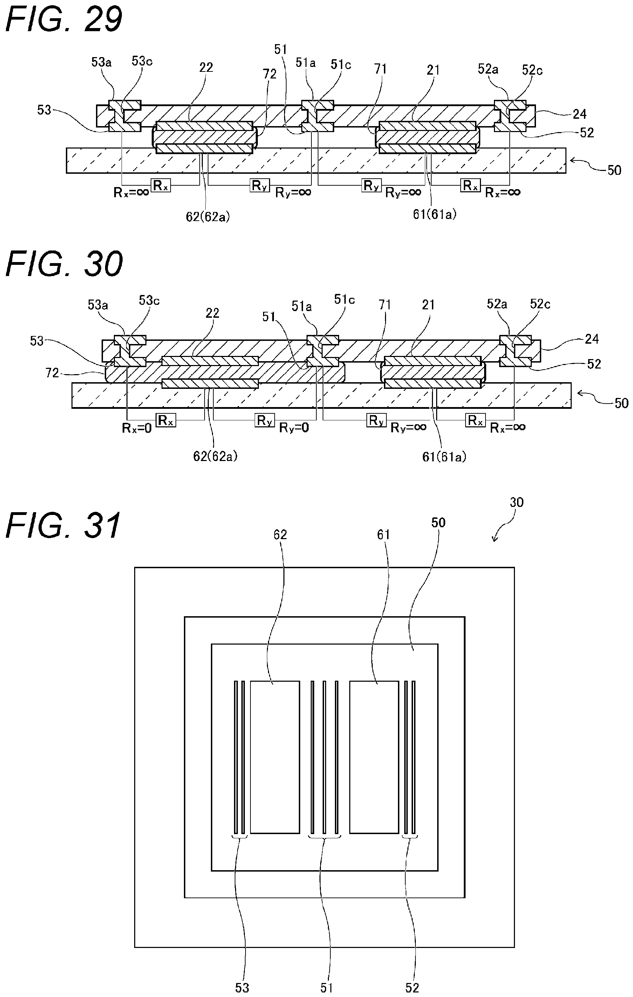

Fig. 29 is a partially enlarged explanatory diagram illustrating a bonded state when wet spreading of the conductive resins 71 and 72 does not occur between the substrate 50 and the Peltier element 20.

In the figure, instead of measuring capacitances Cx and Cy between the terminal 62 and the detection pattern portions 53 and 51 and capacitances Cx and Cy between the terminal 61 and the detection pattern portions 52 and 51, respective resistances Rx and Ry are measured. Other than the above, the method is similar to that in the case of Figs. 27 and 17 in the fifth embodiment, and thus the description thereof will be omitted. In this case, values are all substantially infinite (∞) of the resistances Rx and the resistances Ry.

Fig. 30 is a partially enlarged explanatory diagram illustrating a bonded state when wet spreading of the conductive resin 72 occurs between the substrate 50 and the Peltier element 20.

In Fig. 30, the method of measuring the resistances Rx and Ry is similar to that in the case of Figs. 28 and 18, and thus the description thereof will be omitted. In this case, both are substantially zero ohms (0 Ω) of a value of the resistance Rx between the terminal 62 and the detection pattern portion 53 and a value of the resistance Ry between the terminal 62 and the detection pattern portion 51. As a result, it can be known that the conductive resin 72 wet-spreads and reaches the detection pattern portions 51 and 53.

On the other hand, since wet spreading of the conductive resin 72 does not occur between the terminal 61 and the detection pattern portions 51 and 52, both are substantially infinite (∞) of a value of the resistance Rx between the terminal 61 and the detection pattern portion 52 and a value of the resistance Ry between the terminal 61 and the detection pattern portion 51. Other than the above, the method is similar to that in the case of Fig. 28 in the fifth embodiment, and thus the description thereof will be omitted.

### [Manufacturing Process of Sixth Embodiment]

The manufacturing process of the substrate 50 in the sixth embodiment is similar to the manufacturing process of the fifth embodiment.

Furthermore, the manufacturing process of the Peltier element 20 is similar to the manufacturing process of the fifth embodiment except that the process is unnecessary of covering the detection pattern portions 51, 52, and 53 formed on the lower surface of the heat dissipation plate 24 with the insulators 51b, 52b, and 53b, and thus the description thereof will be omitted.

Other than the above, the manufacturing process is similar to that described with reference to Figs. 6 to 14, and thus the description thereof will be omitted.

### [Effects of Sixth Embodiment]

Since the sixth embodiment of the semiconductor device 101 according to the present disclosure is configured as described above, the processes are unnecessary of forming the detection pattern portions 51, 52, and 53 and the insulators 51b, 52b, and 53b in Figs. 7 to 10, and of applying the alumina coating illustrated in Fig. 8.

Moreover, since the wet spreading inspection of the conductive resins 71 and 72 can be achieved by simply measuring the resistance, it is not necessary to use expensive inspection equipment, a simple checker for conduction inspection is sufficient, and an investment amount of the inspection equipment is small.

The effects of the sixth embodiment of the semiconductor device 101 other than the above are similar to those of the fifth embodiment, and thus the description thereof will be omitted.

### <8. Modification of First Embodiment of Semiconductor Device according to Present Disclosure>

Next, a description will be given of a modification (Hereinafter, it is referred to as "present modification" in the present example.) of the first embodiment of the semiconductor device 101 according to the present disclosure.

In a configuration of the present modification, in Figs. 2 to 5 of the first embodiment, instead of the inspection terminals 61a and 62a, the inspection terminals 21a and 22a as illustrated in Figs. 19 to 22 of the third embodiment are provided to the electrodes 21 and 22. Other than the above, the configuration is the same as that in the first embodiment. Thus, in the present modification, in Figs. 2 to 5, the inspection terminals 21a and 22a in Figs. 19 to 22 are applied.

In the present modification, the wet spreading inspection of the conductive resins 71 and 72 is performed as follows. That is, measurement of the capacitance Cx is performed between the inspection terminals 21a and 52a, which are respective inspection terminals of the electrode 21 on the lower surface of the heat dissipation plate 24 and the detection pattern portion 52 on the upper surface of the substrate 50, and between the inspection terminals 22a and 53a, which are respective inspection terminals of the electrode 22 on the lower surface of the heat dissipation plate 24 and the detection pattern portion 53 on the upper surface of the substrate 50.

Furthermore, measurement of the capacitance Cy is performed between the inspection terminals 21a and 51a, which are respective inspection terminals of the electrode 21 and the detection pattern portion 51 on the upper surface of the substrate 50, and between the inspection terminals 22a and 51a, which are respective inspection terminals of the electrode 22 and the detection pattern portion 51.

Furthermore, since a specific measurement method is similar to that of the first embodiment or the fifth embodiment, the description thereof will be omitted. Since the manufacturing process and the effects are also similar to those of the embodiment described above, the description thereof will be omitted.

### <9. Modification of Second Embodiment of Semiconductor Device according to Present Disclosure>

Next, a description will be given of a modification (Hereinafter, it is referred to as "present modification" in the present example.) of the second embodiment of the semiconductor device 101 according to the present disclosure.

In a configuration of the present modification, in Figs. 15 to 18 of the second embodiment, instead of the inspection terminals 61a and 62a, the inspection terminals 21a and 22a as illustrated in Figs. 23 to 26 of the fourth embodiment are provided to the electrodes 21 and 22. Other than the above, the configuration is the same as that in the second embodiment. Thus, in the present modification, in Figs. 15 to 18, the inspection terminals 21a and 22a in Figs. 23 to 26 are applied.

In the present modification, the wet spreading inspection of the conductive resins 71 and 72 is performed as follows. That is, measurement of the resistance Rx is performed between the inspection terminals 21a and 52a, which are respective inspection terminals of the electrode 21 on the lower surface of the heat dissipation plate 24 and the detection pattern portion 52 on the upper surface of the substrate 50, and between the inspection terminals 22a and 53a, which are respective inspection terminals of the electrode 22 on the lower surface of the heat dissipation plate 24 and the detection pattern portion 53 on the upper surface of the substrate 50.

Furthermore, measurement of the resistance Ry is performed between the inspection terminals 21a and 51a, which are respective inspection terminals of the electrode 21 and the detection pattern portion 51 on the upper surface of the substrate 50, and between the inspection terminals 22a and 51a, which are respective inspection terminals of the electrode 22 and the detection pattern portion 51.

Furthermore, since a specific measurement method is similar to that of the second embodiment or the sixth embodiment, the description thereof will be omitted. Since the manufacturing process and the effects are also similar to those of the embodiment described above, the description thereof will be omitted.

### <10. First Modification of First Embodiment or Second Embodiment of Semiconductor Device according to Present Disclosure>

Next, a description will be given of a first modification of the first embodiment or the second embodiment of the semiconductor device 101 according to the present disclosure (Hereinafter, it is referred to as "first modification" in the present example.).

Fig. 31 is a plan view of the substrate 50 in the cavity 35 before the Peltier element 20 is bonded to the substrate 50 in the first modification. One each of the detection pattern portions 51, 52, and 53 in the first embodiment or the second embodiment is disposed on the upper surface of the substrate 50 in the Y direction along the terminals 61 and 62.

On the other hand, in the first modification, the detection pattern portions 51, 52, and 53 are each disposed in a plurality of detection pattern portions in the Y direction along the terminals 61 and 62 as illustrated in Fig. 31 instead of one each. The figure illustrates an example in which two detection pattern portions are disposed on the left side of the terminal 62, three detection pattern portions are disposed between the terminals 61 and 62, and two detection pattern portions are disposed on the right side of the terminal 61.

In this case, a case where the detection pattern portions 51, 52, and 53 are covered with the insulators 51b, 52b, and 53b, respectively, is the first modification of the first embodiment. Furthermore, a case where the detection pattern portions 51, 52, and 53 are not covered with the insulators 51b, 52b, and 53b, respectively, is the first modification of the second embodiment.

For the above configuration, it is only required to print a paste-like conductive material on the green sheet 90 following the numbers of detection pattern portions so that the numbers of the detection pattern portions 51, 52, and 53 are respective predetermined numbers, in the process illustrated in Fig. 7 in the manufacturing process of the semiconductor device 101.

The detection pattern portions 51, 52, and 53 are disposed in the plurality of detection pattern portions in the Y direction along the terminals 61 and 62 in this manner, whereby it is possible to finely know a state or degree of wet spreading of the conductive resins 71 and 72, and appropriately perform determination of good or bad.

Note that, in the example illustrated in Fig. 19 of the third embodiment or Fig. 23 of the fourth embodiment described above, the detection pattern portions 51, 52, and 53 may be disposed in a plurality of detection pattern portions in the Y direction along the electrodes 21 and 22 on the lower surface of the heat dissipation plate 24.

### <11. Second Modification of First Embodiment or Second Embodiment of Semiconductor Device according to Present Disclosure>

Next, a description will be given of a second modification of the first embodiment or the second embodiment of the semiconductor device 101 according to the present disclosure (Hereinafter, it is referred to as "second modification" in the present example.).

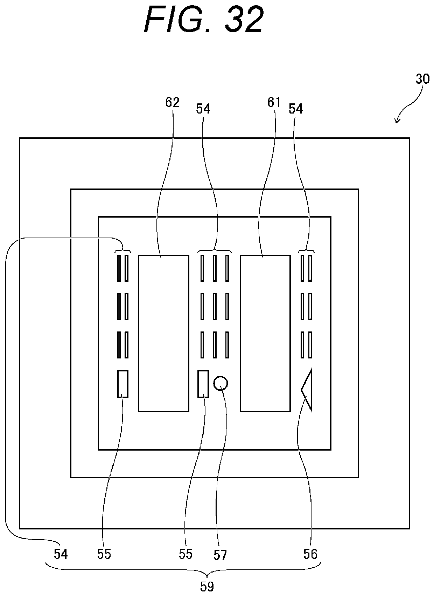

Fig. 32 is a plan view of the substrate 50 in the cavity 35 before the Peltier element 20 is bonded to the substrate 50 in the second modification. In the second modification, each of the detection pattern portions 51, 52, and 53 does not need to be one continuous straight line, and may be a small detection pattern portion 59 having various shapes shorter than longitudinal lengths of the terminals 61 and 62 and the electrodes 21 and 22.

Specifically, as illustrated in Fig. 32, the small detection pattern portion 59 is made by forming shapes of the detection pattern portions 51, 52, and 53 into a short linear shape pattern 54, a rectangular shape pattern 55, a triangular shape pattern 56, a circular shape pattern 57, or the like. In the figure, a plurality of the small detection pattern portions 59 is disposed in the Y direction along the terminals 61 and 62. Note that the shape, number, arrangement, and the like of the small detection pattern portions 59 are not particularly limited.

Each of the small detection pattern portions 59 may be connected to an inspection terminal (not illustrated) formed on an upper surface peripheral edge of the substrate 50 via a wiring layer (not illustrated) formed inside a bottom surface of the PGA package 30, for example. Then, the capacitances Cx and Cy or resistances Rx and Ry may be measured between these inspection terminals (not illustrated) and the inspection terminals 61a and 62a.

In this case, a case where the small detection pattern portions 59 each are covered with an insulator (not illustrated) is the second modification of the first embodiment. Furthermore, a case where the substantially circular shape pattern 57 and the like that are the small detection pattern portions 59 each are not covered with an insulator is the second modification of the second embodiment.

For the above configuration, it is only required to print a paste-like conductive material on the green sheet 90 following the shapes and numbers of detection pattern portions so that the shapes and numbers of the small detection pattern portions 59 are respective predetermined shapes and numbers, in the process illustrated in Fig. 7 of the semiconductor device 101.

The small detection pattern portions 59 are disposed in the predetermined shapes and numbers in the Y direction along the terminals 61 and 62 in this manner, whereby it is possible to finely know a state or degree of wet spreading of the conductive resins 71 and 72, and appropriately perform determination of good or bad.

Note that, in the example illustrated in Fig. 19 of the third embodiment and Fig. 23 of the fourth embodiment described above, similarly to the second modification, the detection pattern portions 51, 52, and 53 formed in the small detection pattern portions 59 may be disposed in a plurality of detection pattern portions in the Y direction along the electrodes 21 and 22 on the lower surface of the heat dissipation plate 24.

### <12. First Modification of Third Embodiment to Sixth Embodiment of Semiconductor Device according to Present Disclosure>

Next, a description will be given of a first modification of the third embodiment to the sixth embodiment of the semiconductor device 101 according to the present disclosure (Hereinafter, it is referred to as "first modification" in the present example.).

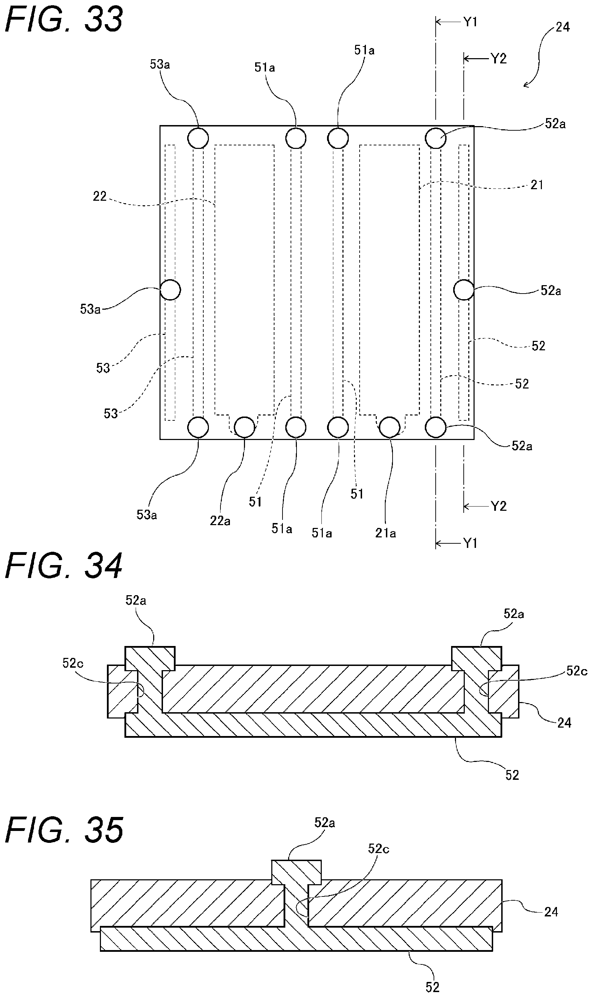

Fig. 33 is a plan view of the heat dissipation plate 24 of the Peltier element 20 in a state where the Peltier element 20 is bonded to the substrate 50 in the first modification in plan view. Furthermore, Fig. 34 is a Y1 end view of Fig. 33, and Fig. 35 is a Y2 end view of Fig. 33.

In each embodiment from the third embodiment to the sixth embodiment, the detection pattern portions 51, 52, and 53 each are disposed in one linear shape on the lower surface of the heat dissipation plate 24 in the Y direction along the electrodes 21 and 22.

On the other hand, in the first modification, the detection pattern portions 51, 52, and 53 are each disposed in a plurality of detection pattern portions on the lower surface of the heat dissipation plate 24 in the Y direction along electrodes 21 and 22 as illustrated in Fig. 33, instead of one each. The figure illustrates an example in which two detection pattern portions are disposed on the left side of the electrode 22, two detection pattern portions are disposed between the electrode 21 and the electrode 22, and two detection pattern portions are disposed on the right side of the electrode 21.

As illustrated in Fig. 33, the detection pattern portions 51, 52, and 53 each disposed in a plurality of detection pattern portions on the lower surface of the heat dissipation plate 24 are connected to the inspection terminals 51a, 52a, and 53a disposed on the upper surface of the heat dissipation plate 24 via the through holes 51c, 52c, and 53c disposed on the peripheral edge of the heat dissipation plate 24. That is, the inspection terminals 51a, 52a, and 53a are connected to both ends or substantially central portions of the detection pattern portions 51, 52, and 53, and are disposed on the peripheral edge of the upper surface of the heat dissipation plate 24.

In this case, a case where the detection pattern portions 51, 52, and 53 are covered with the insulators 51b, 52b, and 53b, respectively, is the first modification of the third embodiment or the fifth embodiment. Furthermore, a case where the detection pattern portions 51, 52, and 53 are not covered with the insulators 51b, 52b, and 53b, respectively, is the first modification of the fourth embodiment or the sixth embodiment.

The above configuration is performed by processes similar to those described in the manufacturing process of the Peltier element 20 in the third embodiment. Then, the Peltier element 20 thus manufactured is bonded to the substrate 50 in the process illustrated in Fig. 14.

The detection pattern portions 51, 52, and 53 are disposed in the plurality of detection pattern portions in the Y direction along the electrodes 21 and 22 in this manner, whereby it is possible to finely know a state or degree of wet spreading of the conductive resins 71 and 72, and appropriately perform determination of good or bad.

### <13. Second Modification of Third Embodiment to Sixth Embodiment of Semiconductor Device according to Present Disclosure>

Next, a description will be given of a second modification of the third embodiment to the sixth embodiment of the semiconductor device 101 according to the present disclosure (Hereinafter, it is referred to as "second modification" in the present example.).

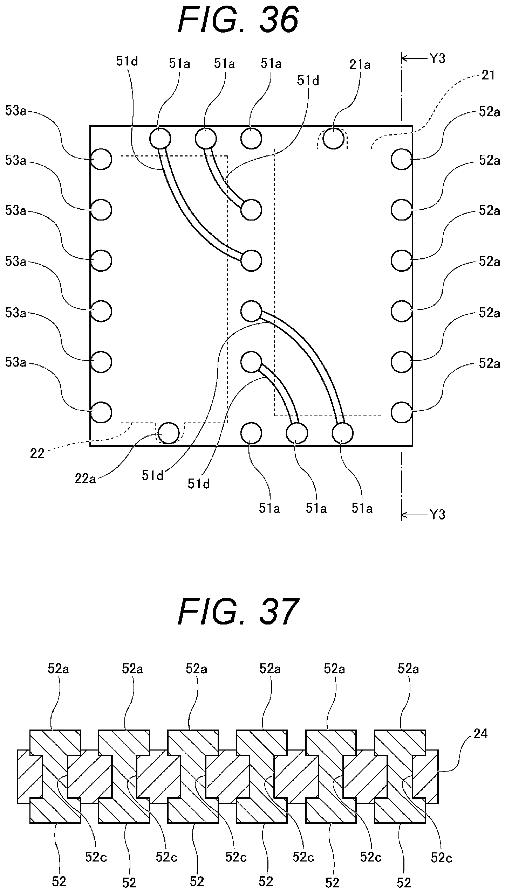

Fig. 36 is a plan view of the heat dissipation plate 24 of the Peltier element 20 in a state where the Peltier element 20 is bonded to the substrate 50 in the second modification in plan view. Furthermore, Fig. 37 is a Y3 end view of Fig. 36.

In the first modification of the third embodiment to the sixth embodiment, each of the detection pattern portions 51, 52, and 53 disposed in a plurality of detection pattern portions is formed in one linear shape.

On the other hand, in the second modification, each of the detection pattern portions 51, 52, and 53 does not need to have one linear shape, and as illustrated in Fig. 36 or 37, is formed in a plurality of substantially circular shape patterns, and these are linearly arranged at predetermined intervals.

As illustrated in Fig. 37, these detection pattern portions 52 and 53 are connected to the respective inspection terminals 51a, 52a, and 53a disposed on the peripheral edge of the upper surface of the heat dissipation plate 24 via the through holes 52c and 53c. Furthermore, the detection pattern portions 51 are connected to the respective inspection terminals 51a disposed on the peripheral edge of the upper surface of the heat dissipation plate 24 via the through holes 51c and wiring patterns 51d.

Fig. 36 or 37 illustrates an example in which six detection pattern portions 53 formed in the substantially circular shape pattern 57 on the left side of the electrode 22, six detection pattern portions 51 between the electrodes 21 and 22 in the same manner, and six detection pattern portions 52 on the right side of the electrode 21 in the same manner each are arranged in one row. Note that the number of pieces to be arranged is not limited to six, and may be any number. Furthermore, the shape of each of the detection pattern portions 51, 52, and 53 may be a small detection pattern portion 59 having a shape other than the substantially circular shape pattern 57 as in Fig. 32.

In this case, a case where the substantially circular shape pattern 57 and the like that are the small detection pattern portions 59 each are covered with an insulator (not illustrated) is the second modification of the third embodiment or the fifth embodiment. Furthermore, a case where the small detection pattern portions 59 each are not covered with an insulator is the second modification of the fourth embodiment or the sixth embodiment.

Such a configuration of the heat dissipation plate 24 is performed by processes similar to those described in the manufacturing process of the Peltier element 20 in the third embodiment. Then, the Peltier element 20 thus manufactured is bonded to the substrate 50 in the process illustrated in Fig. 14.

As described above, the plurality of detection pattern portions 51, 52, and 53 each are arranged in a plurality of detection pattern portions linearly in the Y direction at predetermined intervals, whereby a position of wet spreading of the conductive resins 71 and 72 can be detected, so that data of a state or degree of wet spreading can be obtained nondestructively. As a result, it is possible to appropriately perform determination of good or bad, and it is possible to utilize it for investigation of a cause of wet spreading and countermeasures therefor.

### <14. Electronic Apparatus Including Semiconductor Device according to Present Disclosure>

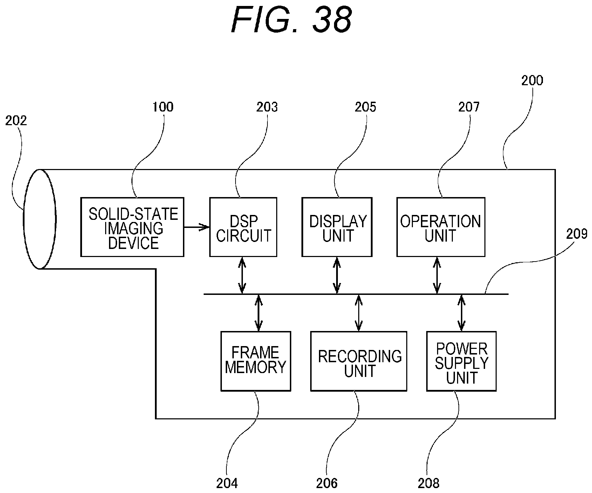

A description will be given of a configuration example of an electronic apparatus including the solid-state imaging device 100 as an example of the semiconductor device 101 according to the first embodiment to the sixth embodiment and the modifications thereof, with reference to Fig. 38.

The semiconductor device 101 according to the present disclosure can be applied to an industrial manufacturing device, an imaging apparatus using the solid-state imaging device 100 as an image reading unit such as a copying machine, an imaging device such as a digital still camera or a video camera, or a mobile terminal device having an imaging function. Furthermore, application thereof is not limited to the imaging apparatus, and can be widely applied to a general electronic apparatus such as an industrial apparatus including a household electrical appliance, a communication apparatus, and an in-vehicle apparatus.

Note that the solid-state imaging device 100 may be a CMOS sensor or a CCD sensor. Furthermore, the solid-state imaging device 100 may be formed as one chip, or may be in the form of a module having an imaging function in which an imaging unit and a signal processing unit or an optical system are packaged together.

As illustrated in Fig. 38, an imaging device 200 as an electronic apparatus includes an optical unit 202, the solid-state imaging device 100, a digital signal processor (DSP) circuit 203, which is a camera signal processing circuit, a frame memory 204, a display unit 205, a recording unit 206, an operation unit 207, and a power supply unit 208. The DSP circuit 203, the frame memory 204, the display unit 205, the recording unit 206, the operation unit 207, and the power supply unit 208 are connected to one another through a bus line 209.

The optical unit 202 includes a plurality of lenses, and captures incident light (image light) from a subject to form an image on a pixel region (not illustrated) of the solid-state imaging device 100. The solid-state imaging device 100 converts an amount of light of the incident light imaged on the pixel region by the optical unit 202 into an electric signal in a pixel unit to output the electric signal as a pixel signal.

The display unit 205 includes a panel display device, for example, a liquid crystal panel, an organic electro luminescence (EL) panel, or the like, and displays a moving image or a still image captured by the solid-state imaging device 100. The recording unit 206 records the moving image or the still image captured by the solid-state imaging device 100 on a recording medium such as a hard disk or a semiconductor memory.

The operation unit 207 issues operation commands for various functions of the imaging device 200 under operation by a user. The power supply unit 208 appropriately supplies various power sources serving as operation power sources of the DSP circuit 203, the frame memory 204, the display unit 205, the recording unit 206, and the operation unit 207 to these supply targets.

Furthermore, the semiconductor device 101 according to the present disclosure can be widely applied not only to the solid-state imaging device 100 but also to various semiconductor devices 101 constituting circuits such as the DSP circuit 203, the frame memory 204, the recording unit 206, the display unit 205, the operation unit 207, and the like.

As described above, according to the present disclosure, by using the solid-state imaging device 100 that is an example of the semiconductor device 101 according to the present disclosure, it is possible to obtain the high-quality imaging device 200 having excellent cooling performance.

Finally, the description of each of the above-described embodiments is an example of the present disclosure, and the present disclosure is not limited to the above-described embodiments. For this reason, it is needless to say that various modifications other than each of the above-described embodiments can be made according to the design and the like without departing from the technical idea according to the present disclosure. Furthermore, the effects described in the present specification are merely examples and are not limited, and other effects may be further provided.

Note that the present technology can also have the following configurations.
(1) A semiconductor device including:
   a semiconductor element;
   a cooling device on which the semiconductor element is bonded to an upper surface and that transfers heat generated by the semiconductor element to a heat dissipation portion;
   a semiconductor package including a cavity that accommodates the semiconductor element and the cooling device;
   an electrode formed in the heat dissipation portion of the cooling device;
   a terminal formed on a bottom surface of the cavity to face the electrode;
   a conductive resin that bonds the electrode and the terminal together; and
   at least one or more detection pattern portions having conductivity for detecting wet spreading of the conductive resin interposed between the electrode and the terminal.
(2) The semiconductor device according to (1), in which the detection pattern portion is insulated and disposed on a surface on which the terminal is formed, and is configured to detect wet spreading of the conductive resin on the basis of a value of capacitance between the detection pattern portion and the terminal.
(3) The semiconductor device according to (1), in which the detection pattern portion is disposed on a surface on which the terminal is formed in a non-insulated manner, and is configured to detect wet spreading of the conductive resin on the basis of a value of resistance between the detection pattern portion and the terminal.
(4) The semiconductor device according to (1), in which the detection pattern portion is insulated and disposed on a surface on which the electrode is formed, and is configured to detect wet spreading of the conductive resin on the basis of a value of capacitance between the detection pattern portion and the electrode.
(5) The semiconductor device according to (1), in which the detection pattern portion is disposed on a surface on which the electrode is formed in a non-insulated manner, and is configured to detect wet spreading of the conductive resin on the basis of a value of resistance between the detection pattern portion and the electrode.
(6) The semiconductor device according to (1), in which the detection pattern portion is insulated and disposed on a surface on which the electrode is formed, and is configured to detect wet spreading of the conductive resin on the basis of a value of capacitance between the detection pattern portion and the terminal.
(7) The semiconductor device according to (1), in which the detection pattern portion is disposed on a surface on which the electrode is formed in a non-insulated manner, and is configured to detect wet spreading of the conductive resin on the basis of a value of resistance between the detection pattern portion and the terminal.
(8) The semiconductor device according to (1), in which the detection pattern portion is insulated and disposed on a surface on which the terminal is formed, and is configured to detect wet spreading of the conductive resin on the basis of a value of capacitance between the detection pattern portion and the electrode.
(9) The semiconductor device according to (1), in which the detection pattern portion is disposed on a surface on which the terminal is formed in a non-insulated manner, and is configured to detect wet spreading of the conductive resin on the basis of a value of resistance between the detection pattern portion and the electrode.
(10) The semiconductor device according to any of (1) to (3), (8), or (9), in which the detection pattern portion is formed linearly, and at least one detection pattern portion is disposed between a plurality of the terminals and between the terminal and an inner wall of the cavity.
(11) The semiconductor device according to any of (1) to (3), (8), or (9), in which the detection pattern portion is formed in a plurality of small detection pattern portions, and a plurality of the detection pattern portions is disposed between a plurality of the terminals and between the terminal and an inner wall of the cavity.
(12) The semiconductor device according to any of (1) or (4) to (7), in which the detection pattern portion is formed linearly, and at least one detection pattern portion is disposed between a plurality of the electrodes and between the electrode and an inner wall of the cavity.
(13) The semiconductor device according to any of (1) or (4) to (7), in which the detection pattern portion is formed in a plurality of small detection pattern portions, and a plurality of the detection pattern portions is disposed between a plurality of the electrodes and between the electrode and an inner wall of the cavity.
(14) The semiconductor device according to (11) or (13), in which the small detection pattern portion is formed in a substantially short linear shape, a substantially rectangular shape, a substantially triangular shape, or a substantially circular shape in plan view.
(15) The semiconductor device according to any of (1), (2), (4), (6), (8), or (10) to (14), in which insulation of the detection pattern portion is aluminum oxide (Al₂O₃).
(16) The semiconductor device according to any of (1), (2), (4), (6), (8), or (10) to (14), in which insulation of the detection pattern portion is an insulating resin.
(17) The semiconductor device according to any of (1) to (16), in which the cooling device includes a Peltier element.
(18) An electronic apparatus including a semiconductor device including:
   a semiconductor element;
   a cooling device on which the semiconductor element is bonded to an upper surface and that transfers heat generated by the semiconductor element to a heat dissipation portion;
   a semiconductor package including a cavity that accommodates the semiconductor element and the cooling device;
   an electrode formed in the heat dissipation portion of the cooling device;
   a terminal formed on a bottom surface of the cavity to face the electrode;
   a conductive resin that bonds the electrode and the terminal together; and
   at least one or more detection pattern portions having conductivity for detecting wet spreading of the conductive resin interposed between the electrode and the terminal.

### REFERENCE SIGNS LIST

- 10: Semiconductor element
- 10a: Connection terminal
- 11: Die bond material
- 20: Peltier element
- 21: Electrode
- 21c: Through hole
- 22: Electrode
- 22c: Through hole
- 23: Ceramic substrate on heat absorption side (heat absorption plate)
- 24: Ceramic substrate (heat dissipation plate) on heat dissipation side
- 25: N-type semiconductor
- 26: P-type semiconductor
- 30: PGA package
- 31: Package frame body
- 31a: Connection terminal
- 31b: Wiring line
- 31c: Via
- 31d: Pad
- 32: Glass lid
- 33: Gold wire (Au)
- 34: Pin
- 35: Cavity
- 50: Substrate
- 51: Detection pattern portion
- 51a: Inspection terminal
- 51b: Insulator
- 51c: Through hole
- 51d: Wiring pattern
- 52: Detection pattern portion
- 52a: Inspection terminal
- 52b: Insulator
- 52c: Through hole
- 53: Detection pattern portion
- 53a: Inspection terminal
- 53b: Insulator
- 53c: Through hole
- 54: Short linear shape pattern
- 55: Rectangular shape pattern
- 56: Triangular shape pattern
- 57: Circular shape pattern
- 59: Small detection pattern portion
- 61: Terminal
- 61a: Inspection terminal
- 61d: Wiring pattern
- 62: Terminal
- 62a: Inspection terminal
- 62d: Wiring pattern
- 65: Conductive metal
- 71: Conductive resin
- 72: Conductive resin
- 90: Green sheet
- 100: Solid-state imaging device
- 101: Semiconductor device
- 200: Imaging device
- Cx, Cy: Capacitance
- Rx, Ry: Resistance

## Claims

1. A semiconductor device comprising:
a semiconductor element;
a cooling device on which the semiconductor element is bonded to an upper surface and that transfers heat generated by the semiconductor element to a heat dissipation portion;
a semiconductor package including a cavity that accommodates the semiconductor element and the cooling device;
an electrode formed in the heat dissipation portion of the cooling device;
a terminal formed on a bottom surface of the cavity to face the electrode;
a conductive resin that bonds the electrode and the terminal together; and
at least one or more detection pattern portions having conductivity for detecting wet spreading of the conductive resin interposed between the electrode and the terminal.

2. The semiconductor device according to claim 1, wherein the detection pattern portion is insulated and disposed on a surface on which the terminal is formed, and is configured to detect wet spreading of the conductive resin on a basis of a value of capacitance between the detection pattern portion and the terminal.

3. The semiconductor device according to claim 1, wherein the detection pattern portion is disposed on a surface on which the terminal is formed in a non-insulated manner, and is configured to detect wet spreading of the conductive resin on a basis of a value of resistance between the detection pattern portion and the terminal.

4. The semiconductor device according to claim 1, wherein the detection pattern portion is insulated and disposed on a surface on which the electrode is formed, and is configured to detect wet spreading of the conductive resin on a basis of a value of capacitance between the detection pattern portion and the electrode.

5. The semiconductor device according to claim 1, wherein the detection pattern portion is disposed on a surface on which the electrode is formed in a non-insulated manner, and is configured to detect wet spreading of the conductive resin on a basis of a value of resistance between the detection pattern portion and the electrode.

6. The semiconductor device according to claim 1, wherein the detection pattern portion is insulated and disposed on a surface on which the electrode is formed, and is configured to detect wet spreading of the conductive resin on a basis of a value of capacitance between the detection pattern portion and the terminal.

7. The semiconductor device according to claim 1, wherein the detection pattern portion is disposed on a surface on which the electrode is formed in a non-insulated manner, and is configured to detect wet spreading of the conductive resin on a basis of a value of resistance between the detection pattern portion and the terminal.

8. The semiconductor device according to claim 1, wherein the detection pattern portion is insulated and disposed on a surface on which the terminal is formed, and is configured to detect wet spreading of the conductive resin on a basis of a value of capacitance between the detection pattern portion and the electrode.

9. The semiconductor device according to claim 1, wherein the detection pattern portion is disposed on a surface on which the terminal is formed in a non-insulated manner, and is configured to detect wet spreading of the conductive resin on a basis of a value of resistance between the detection pattern portion and the electrode.

10. The semiconductor device according to claim 1, wherein the detection pattern portion is formed linearly, and at least one detection pattern portion is disposed between a plurality of the terminals and between the terminal and an inner wall of the cavity.

11. The semiconductor device according to claim 1, wherein the detection pattern portion is formed in a plurality of small detection pattern portions, and a plurality of the detection pattern portions is disposed between a plurality of the terminals and between the terminal and an inner wall of the cavity.

12. The semiconductor device according to claim 1, wherein the detection pattern portion is formed linearly, and at least one detection pattern portion is disposed between a plurality of the electrodes and between the electrode and an inner wall of the cavity.

13. The semiconductor device according to claim 1, wherein the detection pattern portion is formed in a plurality of small detection pattern portions, and a plurality of the detection pattern portions is disposed between a plurality of the electrodes and between the electrode and an inner wall of the cavity.

14. The semiconductor device according to claim 11, wherein the small detection pattern portion is formed in a substantially short linear shape, a substantially rectangular shape, a substantially triangular shape, or a substantially circular shape in plan view.

15. The semiconductor device according to claim 1, wherein insulation of the detection pattern portion is aluminum oxide (Al₂O₃).

16. The semiconductor device according to claim 1, wherein insulation of the detection pattern portion is an insulating resin.

17. The semiconductor device according to claim 1, wherein the cooling device includes a Peltier element.

18. An electronic apparatus comprising a semiconductor device including:
a semiconductor element;
a cooling device on which the semiconductor element is bonded to an upper surface and that transfers heat generated by the semiconductor element to a heat dissipation portion;
a semiconductor package including a cavity that accommodates the semiconductor element and the cooling device;
an electrode formed in the heat dissipation portion of the cooling device;
a terminal formed on a bottom surface of the cavity to face the electrode;
a conductive resin that bonds the electrode and the terminal together; and
at least one or more detection pattern portions having conductivity for detecting wet spreading of the conductive resin interposed between the electrode and the terminal.
